# EUROPEAN PATENT SPECIFICATION

(11) **EP 4 439 080 B1**
(45) Date of publication and mention of the grant of the patent: **09.12.2026**
(21) Application number: 23164243.0
(22) Date of filing: 27.03.2023
(51) Int. Cl.: G01R 13/02, G01R 31/28

(54) **MEASUREMENT APPLICATION DEVICE, SIGNAL PROCESSING SYSTEM, QUBIT CONTROL UNIT, AND QUANTUM COMPUTER**
MESSANWENDUNGSVORRICHTUNG, SIGNALVERARBEITUNGSSYSTEM, QUBIT-STEUEREINHEIT UND QUANTENCOMPUTER
DISPOSITIF D'APPLICATION DE MESURE, SYSTÈME DE TRAITEMENT DE SIGNAL, UNITÉ DE COMMANDE DE BITS QUANTIQUES ET ORDINATEUR QUANTIQUE

(43) Date of publication of application: 02.10.2024
(73) Proprietor: Rohde & Schwarz GmbH & Co. KG, 81671 München (DE)
(72) Inventor: SCHENKEL, Fabian, 8102 Oberengstringen (CH); RUEHLE, Christoph, 76131 Karlsruhe (DE)
(74) Representative: Novagraaf Group

(56) References cited:
- CN-A- 109 828 631
- CN-A- 111 565 046
- US-A1- 2013 307 509
- LIN JIN ET AL: "Scalable and customizable arbitrary waveform generator for superconducting quantum computing", AIP ADVANCES, AMERICAN INSTITUTE OF PHYSICS, 2 HUNTINGTON QUADRANGLE, MELVILLE, NY 11747, vol. 9, no. 11, 18 November 2019 (2019-11-18), XP012242264, DOI: 10.1063/1.5120299

## Description

### TECHNICAL FIELD

The disclosure relates to a measurement application device. Further, the present disclosure relates to a signal processing system, a qubit control unit, and a quantum computer.

### BACKGROUND

Although applicable to any type of measurement application device, the present disclosure will mainly be described in conjunction with synchronized signal generation and acquisition with connected measurement application devices.

Modern electronic measurement applications may comprise a plurality of measurement channels and signal generation channels. In such measurement applications it is crucial that all signal input and output channels are synchronized in a way to provide both deterministic as well as aligned latency over all channels.

Maintaining deterministic and aligned latency is not only required between consecutive experiment runs or measurements, but in some applications also between power-cycles of any of the measurement equipment, as well as during environmental changes like temperature variations over time.

Maintaining such strict synchronization is difficult to achieve, especially in communicatively coupled measurement devices.

Document US 2013 / 0 307 509 A1 discloses a digital event generator. Document CN 111565046 A discloses a multi-board synchronous acquisition circuit and method based on JESD204B. Document CN 109828631 A discloses an arbitrary waveform generation system. Document XP 12242264A discloses a scalable and customizable arbitrary waveform generator for superconducting quantum computing.

There is a need for improving synchronization of measurement application devices.

### SUMMARY

The above stated problem is solved by the features of the independent claims. It is understood, that independent claims of a claim category may be formed in analogy to the dependent claims of another claim category.

The present disclosure is based on the finding that known synchronization techniques may not reliably synchronize multiple measurement application devices or even multiple measurement domains or processing domains e.g., formed each by an FPGA and respective peripheral circuity, in a single measurement application device.

For example, the JEDEC Standard JESD204B subclass 1 and subclass 2 defines techniques to provide deterministic latency with multiple converters that are attached using a JESD204B interface.

Especially, when a plurality of measurement channels and/or signal generation channels is required in a measurement application, it is difficult to provide a reliable synchronization.

Different channels in different DSP domains e.g., in different measurement application devices or in different FPGAs of the same measurement application device, may be used in a synchronized way today. Some approaches rely on an external, centralized controller providing a trigger signal to each one of the measurement application devices or DSP domains. The trigger signal may be used to synchronously start the playback or analysis of the different channels.

However, in such systems care must be taken to properly synchronize the incoming external trigger signal to the digital clock within each of the individual DSP domains. Such clock synchronizations inherently exhibit variable latency unless care is taken that the external trigger pulse arrives in a carefully timed manner at the synchronization elements, for the setup and hold times of the corresponding flip flops being met. Additionally, if multiple DSP domains are to be triggered at the same time, the trigger pulses must be timed to fulfill the setup and hold times of all DSP domains that are to be triggered at the same time.

Further the propagation time of the trigger signals from the central controller to all DSP domains is crucial for the aforementioned reasons. With an increasing scaling of the system and thus an increasing number of individual DSP domains involved, providing the trigger signals at the same time to all DSP domains becomes increasingly difficult. For example, a single controller might not be able to have an individual trigger signal line to each DSP domain. Some hierarchical trigger distribution layer may in such cases be added, which makes deterministic trigger distribution even more challenging. Further, since a trigger is typically required for each single measurement or experiment run, the propagation times of the trigger signals must be kept stable during the entire uptime of the whole system, which requires accounting for environmental changes like temperature variances.

Any variance in trigger timing will inevitably lead to different trigger arrival times in the different DSP domains. Since the DSP domains are typically clocked at considerably lower frequencies, usually few hundred MHz, than actual analog-to-digital converter clocks or digital-to-analog converter clocks they feed, usually multiple GHz, a difference of only one single DSP clock cycle can easily lead to a latency mismatch of multiple sampling clocks in the analog signal's domain.

In the context of the present disclosure, a DSP domain may refer to the digital signal processing components that are provided to handle at least one analog-to-digital converter or digital-to-analog converter, but do not include the analog-to-digital converter or digital-to-analog converter and respective peripherals. The analog-to-digital converter or digital-to-analog converter may be referred to as the analog domain, AD-domain, or DA-domain. A single measurement application device may comprise one DSP domain or multiple DSP domains. Further, the elements of a measurement application device according to the present disclosure that perform digital functions may be implemented in the DSP domain.

In order to improve synchronization in measurement applications, the present disclosure provides the measurement application device with a synchronization interface. The synchronization interface may be implemented as or comprise an interface like the JEDEC Standard JESD204B interface and may receive respective synchronization signals. It is understood, that the JEDEC Standard JESD204B is just one of multiple possible examples of the synchronization interface. Generally, any type of synchronization method or interface may be used. Alternative methods include but are not limited to modulating the synchronization signal on top of a reference clock signal. This method would only require one single signal. Compared to the JEDEC Standard the SYSREF signal would not be required. A further exemplary method comprises an amplitude modulation method that comprises skipping one clock cycle of the reference clock, instead of an edge on the SYSREF signal as in the JEDEC Standard, the "missing" clock cycle marks the synchronization event for the counters. Another exemplary method comprises switching the phase of the reference clock signal, wherein switching between phase polarities marks the synchronization event.

The measurement application device further comprises a counter that is coupled to the synchronization interface. The counter may receive the synchronization signals to synchronize with other counters, for example in other measurement application devices or other DSP domains of the same measurement application device. The counter will, therefore, generate and output a counter signal based on the received synchronization signals i.e., after being synchronized based on the received synchronization signals. Again, the method according to the JEDEC Standard JESD204B may as one of multiple exemplary methods be used to perform the synchronization.

In a signal processing system according to the present disclosure with at least two measurement application devices i.e., two, or three or more measurement application devices according to the present disclosure, the counters of the measurement application devices will therefore be synchronized based on the synchronization signals. To this end, the signal processing system comprises a respective synchronization signal source that is coupled to the measurement application devices and provides the synchronization signals to the measurement application devices. In embodiments, the signal processing system may comprise only one measurement application device that comprises multiple counters. Such a measurement application device may e.g., comprise multiple DSP domains that all comprise a dedicated counter and each serve one, two or more analog channels.

The synchronization signals of the present disclosure are not to be misunderstood as trigger signals. Traditional, centrally generated trigger signals serve to trigger e.g., measurements in a measurement application device. The synchronization signals, in contrast, only serve to synchronize the counters of all measurement application devices in the signal processing system and not to trigger the respective measurement application devices to perform any type of action.

The synchronization of the counters may be performed only once after the startup of the signal processing system. As long as the counter, also called clock, is running without interruption, all measurement application devices will have access to a counter signal that indicates or represents a counter value, that gives the exact same time value in each of the measurement application devices. Of course, this also applies to multiple DSP domains in the same measurement application device. Tight timing requirements for synchronization only need to be maintained at the beginning, until all counters are synchronized in the signal processing system. After an initial synchronization process, additional influences like changes in signal propagation due to thermal expansion are not relevant anymore. The counters may be entirely digital, and may be clocked by a common master clock. All counter values are, therefore, derived from the same reference clock. If the reference clock drifts due to temperature, all counters drift alike, but are kept synchronous between themselves. Of course, multiple synchronizations of the single counters in the measurement application device or the signal processing system may be performed if adequate or beneficial.

The measurement application device further comprises an event signal generator that is coupled to the counter and receives the counter signal. The counter signal, also called timer signal or time, serves as a base, especially time base, for the event signal generator to generate respective event signals for each one of one or more predefined event times.

The event times may be provided to the measurement application device from any external source e.g., via a respective interface, especially a communication or data interface. The event times define a counter value that is to be provided by or that is expected in the counter signal to generate the respective event signal. In embodiments, the event signal may be seen as or be used as a trigger signal in the respective measurement application device.

The predetermined event times in the context of the present disclosure may be seen as a kind of or comprise an "absolute trigger time" for the signal processing system or the respective measurement application devices that may be provided to the event signal generators of all measurement application devices in the signal processing system or to a selection of the event signal generators of the measurement application devices in the signal processing system. As soon as a counter reaches this "absolute trigger time" the event signal generator in the respective measurement application device of the signal processing system will generate the respective event signal. Therefore, if the same predetermined event time is provided to all measurement application devices, the trigger mechanisms in the measurement application devices simply will wait until the received event time matches the current value of the respective counter and generate a respective trigger signal.

Whenever the two times i.e., the counter value and the respective predetermined event time, match, a respective event signal will be issued by the respective event signal generator. The event signals may e.g., at least one of start a playback or a signal analysis in the respective DSP domain or the respective at least one analog channel. Since all measurement application devices comprise perfectly aligned counters and respective counter signals, and each measurement application device is provided with the same event time, all actions will always be triggered in a cycle-accurate manner in the measurement application devices.

In the signal processing system, an event controller distributes one or multiple predetermined event times to at least one, two or to all measurement application devices or DSP domains. However, compared to known methods, the propagation time of this distribution is not time-critical in the signal processing system according to the present disclosure. It does not matter if the event times arrive earlier in one of the measurement application devices or DSP domains than in others, as long as the event times arrive in each measurement application device or DSP domain before the event is due i.e., before the counters arrive at the predetermined event time.

This can easily be achieved by only distributing event times that are sufficiently far in the future to ensure that the event time information will arrive in each measurement application device or DSP domain of the signal processing system before the event time.

With the solution of the present disclosure, there is no limit to how far the event or triggering system can scale with system size, as long as the required initial synchronization can be properly established as required to synchronize the counters of the measurement application devices. It is understood, that the initial synchronization may also be used to synchronize the used digital-to-analog converters, DACs, and analog-to-digital converters, ADCs, in the measurement application devices. The present disclosure further allows using non-deterministic components as a source of the predetermined event times, such as a standard PCs without real time capabilities.

The synchronization interface of the measurement application device may comprise any type of adequate interface. The synchronization interface may comprise e.g., the above mentioned JEDEC Standard JESD204B interface. Generally, any interface that allows synchronizing the counters may be used. Of course, the synchronization interface may comprise a combination of discrete elements e.g., for implementing the physical interface part, and logic or program functions e.g., for implementing communication and error handling functions. The synchronization interface may in embodiments e.g., be implemented as a combination of a respectively configured FPGA with respective peripheral elements.

The counter may be implemented as a dedicated counter circuit or IC. In embodiments, the counter may also be implemented at least in part as or in a configurable logic element, like an FPGA or a CPLD. A counter may e.g., provide the possibility to reset the counter, especially to zero, and to start and stop the counter via a respective control input. Synchronizing the counters may, therefore, comprise resetting all counters to zero and starting the counters at the same moment. The counters may also comprise configurable clock or tick sources that allow adapting the speed of the respective counter during synchronization.

The event signal generator may comprise a logic device or processing device or a function executed in a logic device or processing device that receives the counter signal as input value, compares the counter signal with the predetermined event times, and outputs an event signal whenever the counter value indicated by the counter signal is equal to the predetermined event time.

The synchronization signal source may comprise any source that is adequate for providing one or multiple signals that are required for performing the synchronization. Such a synchronization signal source may comprise, but is not limited to, a source according to JEDEC Standard JESD204B.

The event controller may comprise any type of superordinate controller that may provide the predetermined event times to the single measurement application devices or DSP domains.

The single elements of the measurement application device and the signal processing system that require or perform at least in part logic functions e.g., the counter, the event signal generator, the synchronization signal source, and the event controller, may be provided as at least one of a dedicated processing element e.g., a processing unit, a microcontroller, a field programmable gate array, FPGA, a complex programmable logic device, CPLD, an application specific integrated circuit, ASIC, or the like. A respective program or configuration may be provided to implement the required functionality. These elements may at least in part also be provided as a computer program product comprising computer readable instructions that may be executed by a processing element. In a further embodiment, these elements may be provided as addition or additional function or method to the firmware or operating system of a processing element that is already present in the respective application as respective computer readable instructions. Such computer readable instructions may be stored in a memory that is coupled to or integrated into the processing element. The processing element may load the computer readable instructions from the memory and execute them.

In addition, it is understood, that any required supporting or additional hardware may be provided like e.g., a power supply circuitry and clock generation circuitry.

A measurement application device according to the present disclosure may comprise any device that may be used in a measurement application to acquire an input signal or to generate an output signal, or to perform additional or supporting functions in a measurement application. A measurement application, also called measurement setup, may e.g., comprise at least one or multiple different measurement application devices for performing electric, magnetic, or electromagnetic measurements, especially on single devices under test. Such electric, magnetic, or electromagnetic measurements may be performed in a measurement laboratory or in a production facility in the respective production line. A measurement application or measurement setup may serve to qualify the single devices under test i.e., to determine the proper electrical operation of the respective devices under test.

Measurement application devices to this end may comprise at least one signal acquisition section for acquiring electric, magnetic, or electromagnetic signals to be measured from a device under test, or at least one signal generation section for generating electric, magnetic, or electromagnetic signals that may be provided to the device under test. Such a signal acquisition section may comprise, but is not limited to, a front-end for acquiring, filtering, and attenuating or amplifying electrical signals. The signal generation section may comprise, but is not limited to, respective signal generators, amplifiers, and filters.

Further, when acquiring signals, measurement application devices may comprise a signal processing section that may process the acquired signals. Processing may comprise converting the acquired signals from analog to digital signals, and any other type of digital signal processing, for example, converting signals from the time-domain into the frequency-domain.

The measurement application devices may also comprise a user interface to display the acquired signals to a user and allow a user to control the measurement application devices. Of course, a housing may be provided that comprises the elements of the measurement application device. It is understood, that further elements, like power supply circuitry, and communication interfaces may be provided.

A measurement application device may be a stand-alone device that may be operated without any further element in a measurement application to perform tests on a device under test. Of course, communication capabilities may also be provided for the measurement application device to interact with other measurement application devices.

A measurement application device may comprise, for example, a signal acquisition device e.g., an oscilloscope, especially a digital oscilloscope, a spectrum analyzer, or a vector network analyzer. Such a measurement application device may also comprise a signal generation device e.g., a signal generator, especially an arbitrary signal generator, also called arbitrary waveform generator, or a vector signal generator. Further possible measurement application devices comprise devices like calibration standards, or measurement probe tips.

Of course, at least some of the possible functions, like signal acquisition and signal generation, may be combined in a single measurement application device.

In embodiments, the measurement application device may comprise pure data acquisition devices that are capable of acquiring an input signal and of providing the acquired input signal as digital input signal to a respective data storage or application server. Such pure data acquisition devices not necessarily comprise a user interface or display. Instead, such pure data acquisition devices may be controlled remotely e.g., via a respective data interface, like a network interface or a USB interface. The same applies to pure signal generation devices that may generate an output signal without comprising any user interface or configuration input elements. Instead, such signal generation devices may be operated remotely via a data connection.

A qubit control unit may comprise one or more signal processing systems according to the present disclosure, wherein the measurement application devices may each form or comprise at least one programmable arbitrary waveform generator that allows generating pulse sequences with known pulse shapes and timings of the pulses. One arbitrary waveform generator channel may be connected to one qubit, in each case, while the pulse shape and timing of the pulses provided by the respective arbitrary waveform generator control the state of the qubit.

A quantum computer may comprise multiple qubits, and signal processing systems according to the present disclosure with respective measurement application devices to provide each qubit with respective signals. In order to operate such a quantum computer multiple arbitrary waveform generator channels that have a deterministic timing relationship between each other are required. Such channels may be provided with the signal processing system according to the present disclosure.

Further embodiments of the present disclosure are subject of the further dependent claims and of the following description, referring to the drawings.

In the following, the dependent claims referring directly or indirectly to claim 1 are described in more detail. For the avoidance of doubt, the features of the dependent claims relating to the measurement application device can be combined in all variations with each other and the disclosure of the description is not limited to the claim dependencies as specified in the claim set. Further, the features of the other independent claims may be combined with any of the features of the dependent claims relating to the measurement application device in all variations. Further, although not explicitly claimed, the present disclosure also provides a method for operating a measurement application device, especially generating synchronized event signals in a measurement application device, and a method for synchronizing multiple measurement application devices, especially in a signal processing system, wherein the functions of the respective apparatus-based elements are performed as respective method steps.

In an embodiment, which can be combined with all other embodiments of the measurement application device mentioned above or below, the event signal generator may be configured to generate the respective event signal when the counter signal is equal to a respective one of the at least one predetermined event time i.e., indicates the counter value provided by one of the predetermined event times.

As indicated above, the counter signal may convey or provide a counter value or time of the respective DSP domain. The event signal generator may, consequently, generate the event signal when the counter signal indicates the exact value of a pending predetermined event time. In case that only one predetermined event time is provided to the event signal generator, the counter value needs to match this predetermined event time. In case that multiple predetermined event times are provided to the event signal generator, the counter value needs to match the next pending i.e., not-passed, predetermined event time.

In embodiments, the event signal generator may be configured to consider a pre-event interval or post-event interval when generating the event signal. The event signal generator may, for example, subtract the pre-event interval form the predetermined event time or add the post-event interval to the predetermined event time or the counter value prior to comparing the predetermined event time with the counter value provided in the counter signal.

In another embodiment, which can be combined with all other embodiments of the measurement application device mentioned above or below, the measurement application device may further comprise an analog signal processing unit coupled to the event signal generator, the analog signal processing unit being configured to perform and control a signal generation or a signal acquisition based on the generated event signals.

The analog signal processing unit may comprise at least one of, but is not limited to, analog-to-digital converters, digital-to-analog converters, data memories, filters, attenuators, amplifiers, a frontend of the respective measurement application device, and processing elements for controlling the other elements of the analog signal processing units.

In embodiments of the measurement application device, the synchronization interface, the counter, and the event signal generator may be seen as elements of a DSP domain of the measurement application device, wherein in embodiments multiple DSP domains may share the same synchronization interface. The analog signal processing units, in contrast, may each be seen as a respective analog domain, wherein at least one of the analog domains may be coupled to each one of the DSP domains.

The analog signal processing units may serve to acquire signals in a measurement application. Such analog signal processing units may e.g., be provided in signal acquisition devices as mentioned above. The analog signal processing units may also serve to generate or output signals in a measurement application. Such analog signal processing units may e.g., be provided in signal generation devices as mentioned above.

In a further embodiment, which can be combined with all other embodiments of the measurement application device mentioned above or below, the measurement application device may further comprise a digital signal processing unit coupled to the event signal generator and configured to perform digital signal processing at least in part based on the generated event signals.

The digital signal processing unit may in embodiments form part or be integrated into a respective DSP domain, and may be directly coupled to the event signal generator to receive the event signal. The digital signal processing unit may e.g., be provided as configuration of an FPGA that already implements the event signal generator. In embodiments, the digital signal processing unit may comprise or may be provided in or as part of a dedicated processing element e.g., a processing unit, a microcontroller, a field programmable gate array, FPGA, a complex programmable logic device, CPLD, an application specific integrated circuit, ASIC, or the like. A respective program or configuration may be provided to implement the required functionality. The digital signal processing unit may at least in part also be provided as a computer program product comprising computer readable instructions that may be executed by a processing element. In a further embodiment, the digital signal processing unit may be provided as addition or additional function or method to the firmware or operating system of a processing element that is already present in the respective application as respective computer readable instructions. Such computer readable instructions may be stored in a memory that is coupled to or integrated into the processing element. The processing element may load the computer readable instructions from the memory and execute them.

In addition, it is understood, that any required supporting or additional hardware may be provided like e.g., a power supply circuitry and clock generation circuitry.

The digital signal processing unit may serve in a measurement application device to perform functions on acquired measurement data in the digital domain, like converting the measurement data from a time-domain into a frequency domain, and performing filtering functions. The digital signal processing unit may also serve to perform digital functions on data that is to be used as basis for generating analog signals e.g., in an arbitrary waveform generator.

In a further embodiment, which can be combined with all other embodiments of the measurement application device mentioned above or below the analog signal processing unit and the digital signal processing unit together may form at least one qubit controller configured to control at least one qubit. The qubit controller may comprise or be provided as an arbitrary waveform generator, as already explained above. Such a qubit controller may comprise analog and digital components that together form the arbitrary waveform generator.

In modern quantum computers a plurality of qubits needs to be controlled and read out. In such quantum computers exactly timing the control or reading of the single qubits is crucial for operation of the respective quantum computer. The teaching of the present disclosure may, therefore, be used to easily synchronize controlling and reading-out qubits in a quantum computer.

In embodiments, which can be combined with all other embodiments of the measurement application device mentioned above or below, the analog signal processing unit may operate at a first frequency that is higher than a second frequency at which the digital signal processing unit operates. The counter may be configured to count with the first frequency and the event signal generator may be configured to at least one of generate a respective digital domain event signal according to the second frequency, and generate an analog domain event signal according to the first frequency.

The counter may operate and the respective time signals may be aligned to a respective clock cycle. However, usually, clock frequencies used in DSP domains are typically limited to a few hundred MHz, while the analog domains may use multi-gigahertz sampling clocks, as is the case with modern digital-to-analog converters and analog-to-digital converters. If the counter operates at the frequency of the DSP domain, event signals may only be generated at integer multiples of the frequency of the DSP domain.

Consequently, operating the counters with the frequency of the analog signal processing unit i.e., the analog domain or at least some elements of the analog domain, allows creating event signals in a more fine-grained sequence for the analog signal processing unit.

In another embodiment, which can be combined with all other embodiments of the measurement application device mentioned above or below, the at least one event time comprises at least one of an individual predetermined digital event time for the digital domain event signal, and an individual predetermined analog event time for the analog domain event signal.

As indicated above, the counter may be operated at the frequency of the analog signal processing unit, which is usually higher than the frequency of the digital signal processing unit in a measurement application device. Consequently, the predetermined event times may be provided for the analog signal processing unit independently of the predetermined event times for the digital signal processing unit. Especially, a predetermined event time for the analog signal processing unit may be provided at specific times within a single cycle of the digital signal processing unit, or multiple predetermined event times may be provided for the analog signal processing unit in a single clock cycle of the digital signal processing unit.

With these features, sampling-clock aligned events e.g., triggering events, may be provided by letting the counter increase by multiple increments at once for each clock cycle of the digital signal processing unit, corresponding to the factor between the clock frequencies of the analog signal processing unit and the digital signal processing unit, thereby actually counting in sample clock periods.

The digital signal processing unit or digital part of the signal chain would still be triggered on the lower clock period granularity. Additional counter bits received by performing the "modulo" operation with the counter and the factor between the clock frequency of the analog signal processing unit and the digital signal processing unit, may be used to shuffle the individual parallel samples before sending or getting them to or from the digital-to-analog converters, or the analog-to-digital converters. The event signal generator may for the digital signal processing unit, for example, only use the highest X bits of a counter, for example only the highest 24 bits of a 32-bit counter, and for the analog signal processing unit may also use the lower eight bits of the counter.

In an embodiment, which can be combined with all other embodiments of the measurement application device mentioned above or below, the measurement application device may further comprise an event control interface coupled to the event signal generator, and configured to receive event time data representing the predetermined event time, wherein the event signal generator may be configured to determine the predetermined event data based on the received event time data.

In embodiments, the predetermined event times may be provided to the measurement application device e.g., by a user programming the event times. With the event control interface, the predetermined event times may also be dynamically provided to the measurement application devices.

The measurement application device may comprise any kind of wired and wireless communication interfaces, like for example a network communication interface, especially an Ethernet, wireless LAN or WIFI interface, a USB interface, a Bluetooth interface, an NFC interface, a visible or non-visible light-based interface, especially an infrared interface. It is further understood, that the measurement application device and the event controller may communicate via an intermediary network with each other, and that such a network may comprise any type of network devices, like switches, hubs, routers, firewalls, and different types of network technologies.

The distribution of the predetermined event times may be performed by any non-deterministic source. The predetermined event times simply need to point into the future enough, such that the maximum possible distribution time and any other non-deterministic effects of generating and sending this information e.g., in a switched network, are not longer than the time from the moment of sending the predetermined event time to the time indicated by the predetermined event time.

In further embodiments, which can be combined with all other embodiments of the measurement application device mentioned above or below, the event time data may comprise information about an earliest possible event time of at least one further measurement application device, wherein the event signal generator may be configured to determine an earliest possible event time for the measurement application device, and wherein the event signal generator is configured to at least one of output the determined earliest possible event time, and determine a next event time as the latest one of the earliest possible event time determined for the measurement application device, and the received earliest possible event time of the at least one further measurement application device.

As indicated above, the predetermined event times may be provided by a central event controller. In embodiments, the central event controller may be replaced or combined with a self-alignment of the single counters and event signal generators.

To this end, the event time data provided to the single event signal generators may comprise the earliest possible event time of at least one further measurement application device, especially of all further measurement application devices in a signal processing system. At the same time, the measurement application device may also output its own earliest possible event time to the further measurement application devices. With this information at hand, every measurement application device may on its own determine the next possible event time for the signal processing system. This next possible event time may be determined as the latest option of the earliest possible event time determined for the measurement application device, and the received earliest possible event time of the at least one further measurement application device.

In many applications the duty cycle of the signal processing system needs to be kept as high as possible, meaning that any "dead time" where the system is idle/waiting is to be avoided to increase the system's overall performance.

With the above-described features, the predetermined event time may be determined in a fully distributed way, instead of being defined by a non-deterministic central event controller. With these features, all event signal generators may inform all other event signal generators about the "earliest possible time" they can generate the next event signal. As soon as an event signal generator has this information from all other event signal generators, including its own, at hand, all received "earliest possible times" can be compared and the highest of these times selected. This time is then simply chosen implicitly as the next event time. Since the same exact process to determine the next event time is performed by all event signal generators, the result of this comparison will be deterministic and identical as well.

In another embodiment, which can be combined with all other embodiments of the measurement application device mentioned above or below, the measurement application device may further comprise a sequencer coupled to the counter, and configured to at least one of generate an arbitrary output signal sequence, or acquire and process input signals based on a predetermined sequence comprising sequence commands and a command time associated with at least one of the sequence commands, and based on the counter signal.

The sequencer may especially be used in measurement application devices that may synthesize analog output signals, such as arbitrary waveform generators. Modern sophisticated arbitrary waveform generators typically allow defining the sequence of pulse playback by programmatic means. This is not only possible for signal generators, but also for devices that acquire analog signals and perform input signal analysis. With the sequencer it is possible to implement sequential signal processing for output or generated signals as well as for input or acquired signals.

To this end, a sequence comprising sequence commands may be provided to the sequencer. The sequencer may then process the single sequence commands. In embodiments, the sequencer may be coupled to any other element of the respective measurement application device, especially the analog signal processing unit and/or the digital signal processing unit of a measurement application device, and control the respective elements to perform the actions or functions as indicated by the sequence commands in the sequence.

With the counter in the measurement application device, any latency generated by a (non-deterministic) sequencer, as well as any latencies introduced by queues that are used to decouple said sequencer from the real-time playback part may be completely hidden. For example, an event time may be used to define the start of a sequence. Further, a respective event time may be defined for at least some of the events within a sequence. An event may e.g., comprise a single pulse of a sequence being played or generated, or an input signal being analyzed.

Instead of relying only on an initial event time that starts of the sequence, which then in itself needs to follow a strict timing, parts of a sequence may use a defined event time on their own. This allows completely hiding any latency that is introduced by either the sequence itself, or any queue used to decouple it, since the pre-processing may be performed by the sequencer well in advance such that the provided event time is met for the respective sequence command.

In a further embodiment, which can be combined with all other embodiments of the measurement application device mentioned above or below, the sequencer may be configured to apply preprocessing functions to the single elements of the output signal sequence in advance such that the respective elements are output according to the sequence commands and the command times provided in the sequence.

The sequencer may be provided as at least one of a dedicated processing element e.g., a processing unit, a microcontroller, a field programmable gate array, FPGA, a complex programmable logic device, CPLD, an application specific integrated circuit, ASIC, or the like. A respective program or configuration may be provided to implement the required functionality. The sequencer may at least in part also be provided as a computer program product comprising computer readable instructions that may be executed by a processing element. In a further embodiment, the sequencer may be provided as addition or additional function or method to the firmware or operating system of a processing element that is already present in the respective application as respective computer readable instructions. Such computer readable instructions may be stored in a memory that is coupled to or integrated into the processing element. The processing element may load the computer readable instructions from the memory and execute them. In addition, it is understood, that any required supporting or additional hardware may be provided like e.g., a power supply circuitry and clock generation circuitry.

In an embodiment, which can be combined with all other embodiments of the measurement application device mentioned above or below, the sequencer may be configured to create individual sequence command queues for individual branches in the sequence, and to receive a feedback signal, and to execute the sequence using the individual sequence command queues based on the feedback signal and the command times provided in the sequence.

In some measurement applications the sequences may be influenced during playback by information or feedback signals that are provided from outside of the respective measurement application device or outside of the sequencer.

In order to prevent the introduction of delays by the processing of the feedback signals, the sequencer may implement sequence command queues for single branches in the sequence in advance i.e., prior to reaching the respective sequence commands.

On reception of the feedback signals that determine the conditions for selecting respective branches in the sequencer, the sequencer simply needs to switch to the corresponding queues as defined by the condition. The point of time at which the switching to the respective sequence command queue is performed, will also be defined by a respective event time that is compared against the counter value. All other sequence command queues may in such cases be flushed, and potentially prepared for the next condition, once the condition and queue switching has been performed.

This will hide any latency even in situations where real-time feedback is required in the sequencer, and thus reduce the feedback latency merely to the maximum time it takes for the feedback information to be sent from the source to the destination sequencer or to multiple destination sequencers.

In another embodiment, which can be combined with all other embodiments of the measurement application device mentioned above or below, the measurement application device may further comprise a monitor configured to monitor the operation of the measurement application device for compliance with the at least one predetermined event time.

In scaling measurement application systems with increased size, monitoring that each channel performs exactly as intended is more and more important. A time counter based system allows to easily detect if at any point any one of the predefined event times could not be fulfilled e.g., because an event time was chosen that was not far enough in the future to allow distribution to all event signal generators in the signal processing system, or because the feedback information required for a condition did not arrive before the event time was due. For example, the event signal generator may identify that an event time was chosen that was not far enough in the future and provide a respective alarm signal. The same applies to the feedback information.

The synchronization as described in this disclosure makes sure that all counters have the same counter value. However, across time, temperature and the variances in the digital elements that implement the counters, it may still happen that a counter has a different counter value relative to the other counters in the signal processing system. With the monitor, a self-test may be executed in order to assure that all counters have the same counter value after the synchronization procedure has been executed. For the self-test, a reference signal may e.g., be fed into one of the analog-to-digital converters connected to the respective counter. The reference signal may e.g., be derived from the synchronization signals. The sampled input may then be triggered and time-stamped. The time-stamped inputs may then be compared to assure that all the counters in the system are still fully synchronized. If this is not the case, a further synchronization may be initiated.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a block diagram of an embodiment of a measurement application device according to the present disclosure;
Figure 2 shows a block diagram of an embodiment of another measurement application device according to the present disclosure;
Figure 3 shows a block diagram of an embodiment of another measurement application device according to the present disclosure;
Figure 4 shows a block diagram of an embodiment of another measurement application device according to the present disclosure;
Figure 5 shows a block diagram of an embodiment of another measurement application device according to the present disclosure;
Figure 6 shows a block diagram of an embodiment of another measurement application device according to the present disclosure;
Figure 7 shows a block diagram of an embodiment of a signal processing system according to the present disclosure;
Figure 8 shows a block diagram of an embodiment of a quantum computer according to the present disclosure;
Figure 9 shows a block diagram of an embodiment of another measurement application device according to the present disclosure; and
Figure 10 shows a block diagram of an embodiment of another measurement application device according to the present disclosure.

In the figures like reference signs denote like elements unless stated otherwise.

### DETAILED DESCRIPTION OF THE DRAWINGS

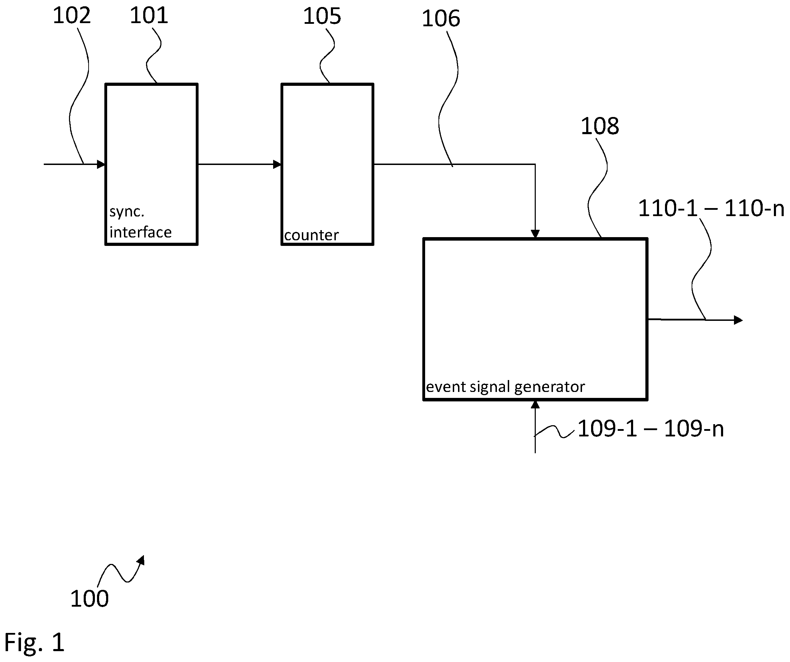

Figure 1 shows a block diagram of a measurement application device 100. The measurement application device 100 comprises a synchronization interface 101 that is coupled to a counter 105. The counter 105 is coupled to an event signal generator 108.

The synchronization interface 101 receives synchronization signals 102 and provides these synchronization signals 102 to the counter 105. The counter 105 is synchronized with the counters of other measurement application devices based on the synchronization signals 102.

After synchronizing, the counter 105 starts counting and outputs a respective counter signal 106. The counter signal 106 at least indicates the current value up to which the counter has counted when providing the counter signal 106. It is understood, that the counter 105 may count to a predetermined maximum value and restart counting from zero after reaching the maximum value. The counter 105 may provide a respective overflow flag in this case.

The counter signal 106 is provided to the event signal generator 108. The event signal generator 108 uses the counter signal 106 to generate an event signal 110-1 - 110-n for each one of a number of predetermined event times 109-1 - 109-n. It is understood, that a single event time or multiple event times 109-1 - 109-n may be provided to the event signal generator 108.

Each of the event times 109-1 - 109-n may characterize the same type of event e.g., a trigger event. In embodiments, the event times 109-1 - 109-n may each further indicate a type of event that is to be generated. This allows to generate different types of events e.g., trigger events and sequencer events for a sequencer as described above or below.

The event signal generator 108 may generate the respective event signals 110-1 - 110-n whenever a counter value indicated by the counter signal 106 is equal to a respective one of the at least one predetermined event times 109-1 - 109-n.

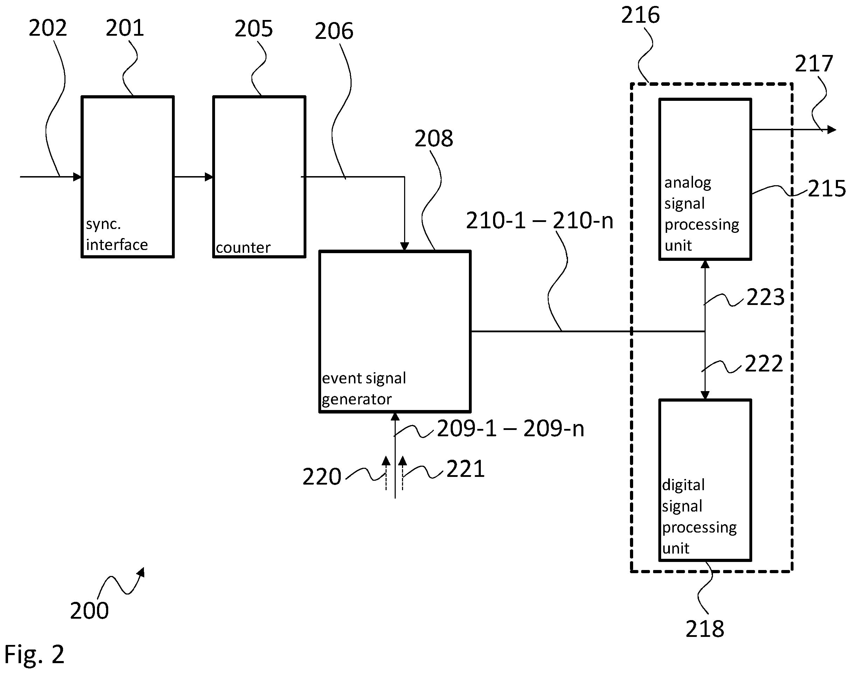

Figure 2 shows a block diagram of another measurement application device 200. The measurement application device 200 is based on the measurement application device 100. Therefore, the measurement application device 200 comprises a synchronization interface 201 that is coupled to a counter 205. The counter 205 is coupled to an event signal generator 208. The explanations provided above for the measurement application device 100 also apply mutatis mutandis to the measurement application device 200.

The measurement application device 200 further comprises an analog signal processing unit 215 and a digital signal processing unit 218 that are both coupled to the event signal generator 208. The analog signal processing unit 215 may comprise circuitry for generating or acquiring analog signals. The analog signal processing unit 215 and the digital signal processing unit 218 together may optionally form a qubit controller 216 that may generate control signals 217 for a qubit. Such a qubit controller 216 may be an arbitrary waveform generator, as explained above.

The digital signal processing unit 218 may generate and acquire digital signals. In embodiments at least one of the synchronization interface 201, the counter 205, and the event signal generator 208 may be provided in the digital signal processing unit 218, and the digital domain event signals 222 may be provided as internal signals to the other elements of the digital signal processing unit 218. The digital signal processing unit 218 may be provided in a respective DSP domain or form part of the DSP domain.

In the embodiment of the measurement application device 200, the event times 209-1 - 209-n may each comprise at least one of a digital event time 220 and an analog event time 221. The event signal generator 208 may respectively generate at least one of a digital domain event signal 222 and an analog domain event signal 223.

It is understood, that in embodiments, the measurement application device 200 may comprise only the analog signal processing unit 215 or the digital signal processing unit 218.

When both, the analog signal processing unit 215 and the digital signal processing unit 218, are present, the analog signal processing unit 215 may operate at a first frequency that is higher than a second frequency at which the digital signal processing unit 218 operates. The counter 105 may in such embodiments count with the first frequency. The event signal generator 108 may then generate the respective digital domain event signals 222 according to the second frequency, and generate the analog domain event signal 223 according to the first frequency.

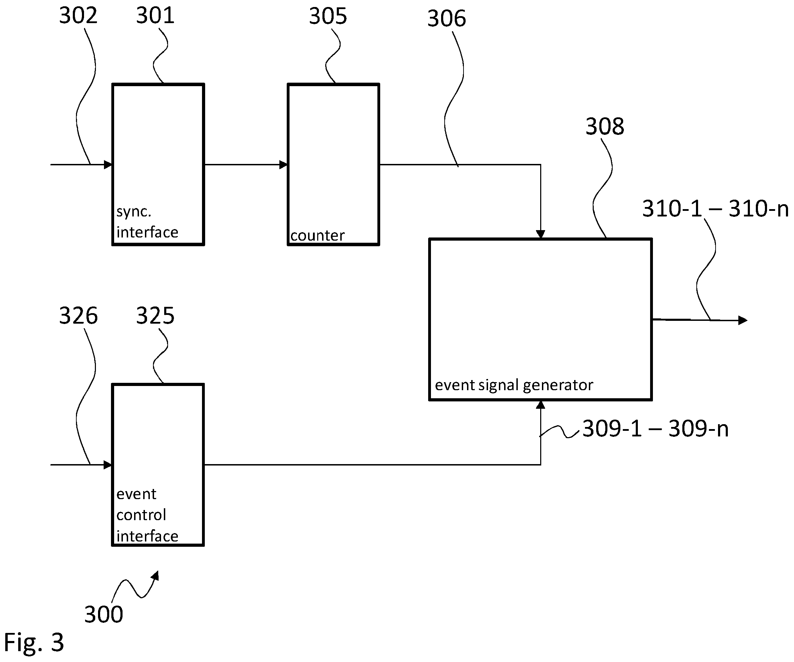

Figure 3 shows a block diagram of a measurement application device 300. The measurement application device 300 is based on the measurement application device 100. Therefore, the measurement application device 300 comprises a synchronization interface 301 that is coupled to a counter 305. The counter 305 is coupled to an event signal generator 308. The explanations provided above for the measurement application device 100 also apply mutatis mutandis to the measurement application device 300.

The measurement application device 300 further comprises an event control interface 325. That is coupled to the event signal generator 308. The event control interface 325 receives event time data 326 that indicates to the event signal generator 308 the event times 309-1 - 309-n. As explained above, the event control interface 325 may be a non-deterministic interface that alone would not be sufficient to provide trigger signals to the single measurement application devices of a signal processing system. However, with the synchronized counter 305, the event times 309-1 - 309-n may be provided will in advance to the event signal generator 308, such that deterministic transmission of a trigger signal is not required.

In embodiments, the event control interface 325 may be used by multiple measurement application devices to determine the next possible event time by themselves. To this end, all measurement application devices may transmit their internal next possible event time to all other measurement application devices. The latest one of all possible event times i.e., of the received and the internal event times, may then be chosen by all measurement application devices as the next event time.

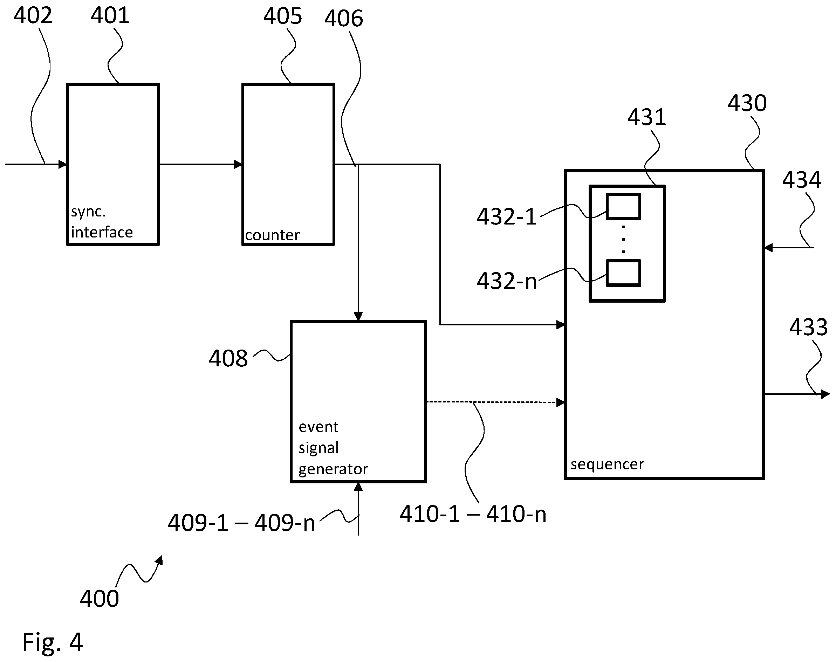

Figure 4 shows a block diagram of a measurement application device 400. The measurement application device 400 is based on the measurement application device 100. Therefore, the measurement application device 400 comprises a synchronization interface 401 that is coupled to a counter 405. The counter 405 is coupled to an event signal generator 408. The explanations provided above for the measurement application device 100 also apply mutatis mutandis to the measurement application device 400.

The measurement application device 400 further comprises a sequencer 430 that is coupled to the counter 405, and optionally also to the event signal generator 408. The sequencer 430 may generate an arbitrary output signal sequence 433 e.g., for providing a required analog waveform in a measurement setup. The sequencer 430 may also control acquisition and processing of input signals 434. The sequencer 430 may operate based on a predetermined sequence 431 of sequence commands 432-1 - 432 and a command time associated with at least one of the sequence commands 432-1 - 432, and based on the counter signal 406.

With the knowledge of the counter value or predetermined event time for at least some of the sequence commands 432-1 - 432-n, the sequencer 430 may apply preprocessing functions to the single elements of the output signal sequence 433 in advance such that the respective elements are output according to the sequence commands 432-1 - 432 and the command times provided in the sequence 431. The same applies to functions that may be required to execute prior to receiving or acquiring input signals 434.

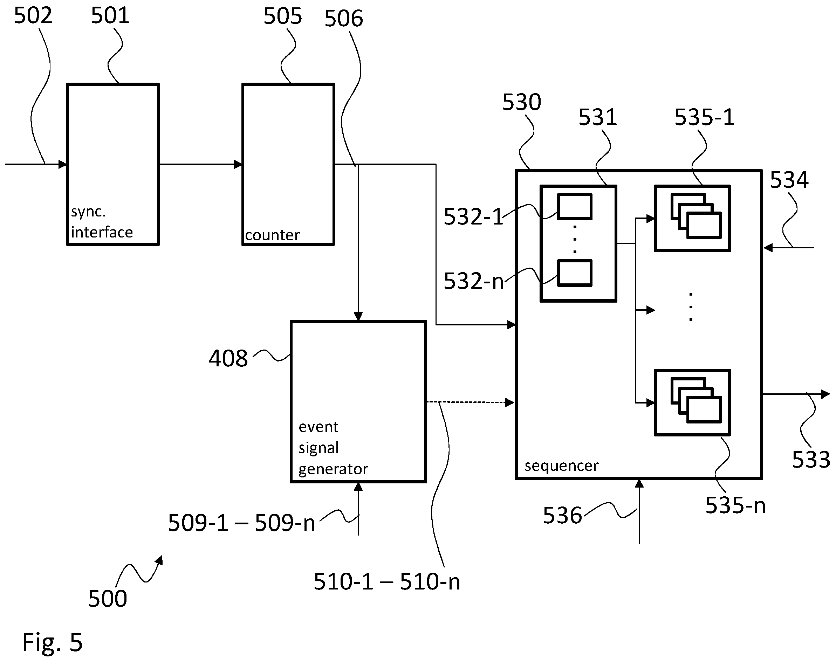

Figure 5 shows a block diagram of a measurement application device 500 that is based on the measurement application device 400. Therefore, the measurement application device 500 comprises a synchronization interface 501 that is coupled to a counter 505. The counter 505 is coupled to an event signal generator 508. The measurement application device 500 further comprises a sequencer 530 that is coupled to the counter 505, and optionally to the event signal generator 508. The explanations provided above for the measurement application device 400 also apply mutatis mutandis to the measurement application device 400.

In the measurement application device 500 the sequencer 530 comprises multiple sequence command queues 535-1 - 535-n for individual branches in the sequence 531.

Such sequences may rely on a received feedback signal 536 to select a respective branch or sequence command queue 535-1 - 535-n.

The sequencer 530 may execute the sequence 531 by selecting and executing the individual sequence command queues 535-1 - 535-n based on the feedback signal 536 and the command times provided in the sequence 531. The only requirement is, therefore, for the feedback signal 536 to arrive sufficiently in advance of the event time for selecting one of the sequence command queues 535-1 - 535-n.

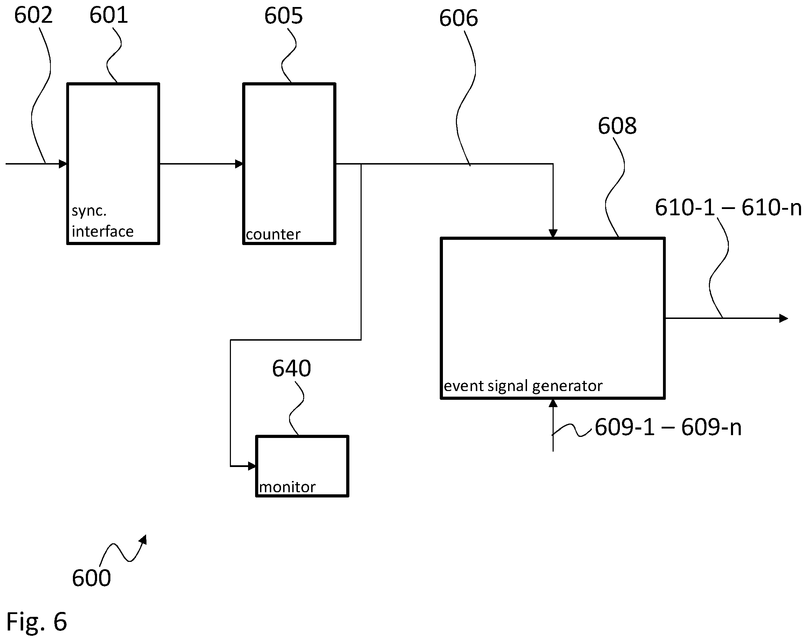

Figure 6 shows a block diagram of another measurement application device 600. The measurement application device 600 is based on the measurement application device 100. Therefore, the measurement application device 600 comprises a synchronization interface 601 that is coupled to a counter 605. The counter 605 is coupled to an event signal generator 608. The explanations provided above for the measurement application device 100 also apply mutatis mutandis to the measurement application device 600.

The measurement application device 600 further comprises a monitor 640 that serves for monitoring the measurement application device 600 for compliance with the predetermined event times 609-1 - 609-n. The monitor 640 may e.g., receive a monitoring signal and time-stamp that signal with the current value of the counter 605. The signal may be derived from the synchronization signals 602, and should, therefore, be time-stamped identically in all measurement application devices. Such a signal may then be provided to a central monitoring unit, where the time-stamps may be compared.

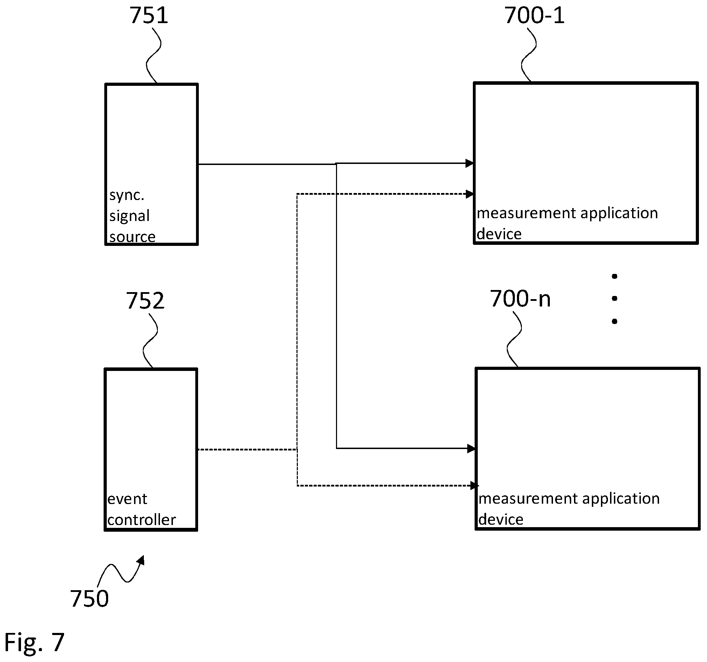

Figure 7 shows a block diagram of a signal processing system 750. The signal processing system 750 comprises a synchronization signal source 751 and an event controller 752 that are both coupled to a number of measurement application devices 700-1 - 700-n. Such a signal processing system 750 may comprise one measurement application device, or two or more measurement application devices 700-1 - 700-n.

The synchronization signal source 751 is coupled to the measurement application devices 700-1 - 700-n via their respective synchronization interfaces, and provides the measurement application devices 700-1 - 700-n the synchronization signals.

The event controller 752 may be coupled to the measurement application devices 700-1 - 700-n via a data interface, and may provide the predetermined event times to the measurement application devices 700-1 - 700-n.

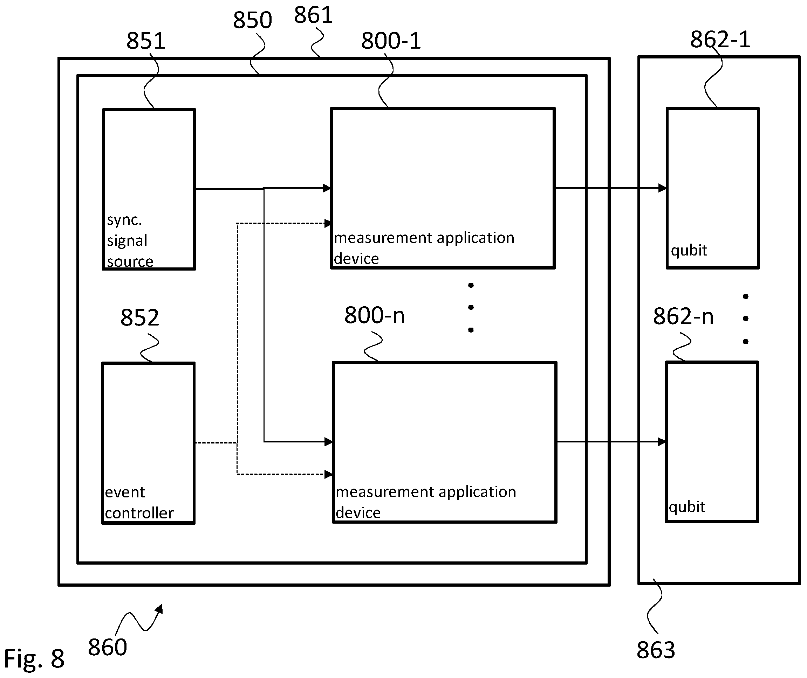

Figure 8 shows a block diagram of an embodiment of a quantum computer 860. The quantum computer 860 comprises a signal processing system 850, as shown in figure 7, and a qubit section 863 with a number of qubits 862-1 - 862-n that are coupled to the measurement application devices 800-1 - 800-n. It is understood, that the quantum computer 860 may comprise any number of qubits 862-1 - 862-n, and that each one of the qubits 862-1 - 862-n may be coupled to one of the measurement application devices 800-1 - 800-n, wherein multiple qubits 862-1 - 862-n may be coupled to each one of the measurement application devices 800-1 - 800-n.

In other embodiments, the quantum computer 860 may comprise only the qubits 862-1 - 862-n, while the signal processing system 850 as control system for the qubits 862-1 - 862-n may be provided externally to the quantum computer 860.

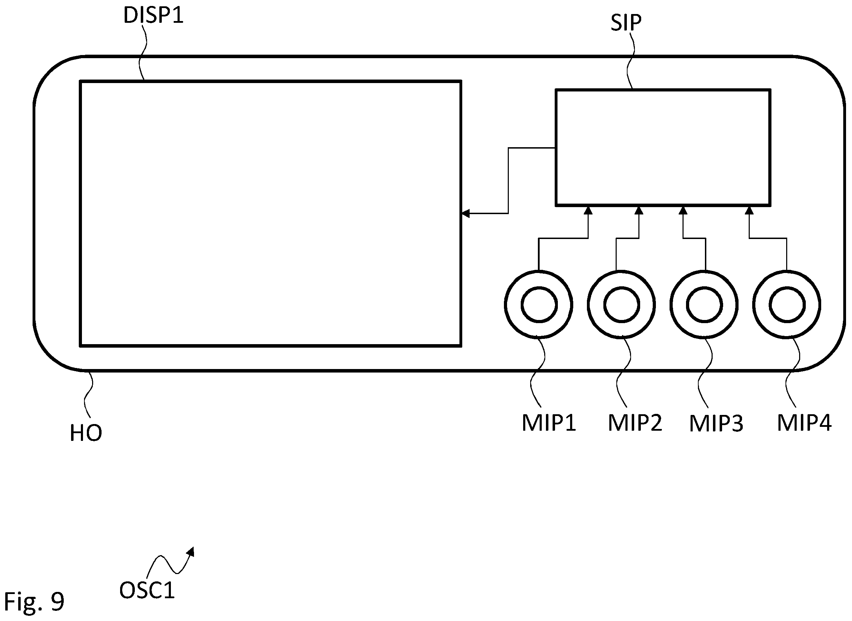

Figure 9 shows a block diagram of an oscilloscope OSC1 that may be used with or as an embodiment of a measurement application device according to the present disclosure.

The oscilloscope OSC1 comprises a housing HO that accommodates four measurement inputs MIP1, MIP2, MIP3, MIP4 that are coupled to a signal processor SIP for processing any measured signals. The signal processor SIP is coupled to a display DISP1 for displaying the measured signals to a user.

Although not explicitly shown, it is understood, that the oscilloscope OSC1 may also comprise signal outputs that may also be coupled to the differential measurement probe. Such signal outputs may for example serve to output calibration signals. Such calibration signals allow calibrating the measurement setup prior to performing any measurement. The process of calibrating and correcting any measurement signals based on the calibration may also be called de-embedding and may comprise applying respective algorithms on the measured signals.

In the oscilloscope OSC1 the signal processor SIP may perform the digital functions or functions that require processing of the elements of the measurement application device. Further, the signal processor SIP may be provided with any element that may be required to provide the functionality of the elements of any of the implementations of the measurement application device described herein.

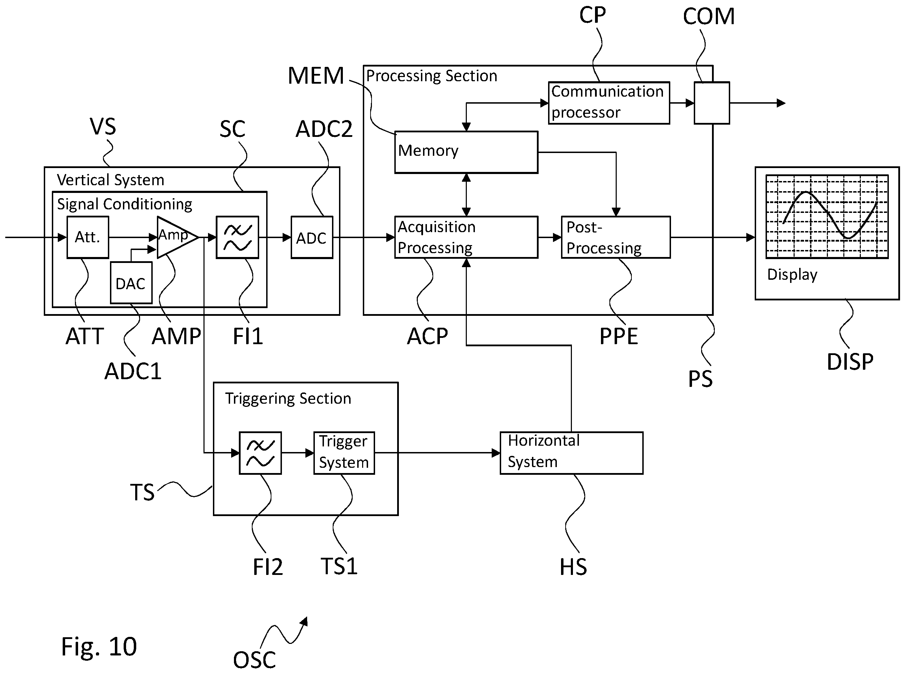

Figure 10 shows a block diagram of an oscilloscope OSC that may be an implementation of a measurement application device according to the present disclosure. The oscilloscope OSC is implemented as a digital oscilloscope. However, the present disclosure may also be implemented with any other type of oscilloscope.

The oscilloscope OSC exemplarily comprises five general sections, the vertical system VS, the triggering section TS, the horizontal system HS, the processing section PS and the display DISP. It is understood, that the partitioning into five general sections is a logical partitioning and does not limit the placement and implementation of any of the elements of the oscilloscope OSC in any way.

The vertical system VS mainly serves for offsetting, attenuating and amplifying a signal to be acquired. The signal may for example be modified to fit in the available space on the display DISP or to comprise a vertical size as configured by a user.

To this end, the vertical system VS comprises a signal conditioning section SC with an attenuator ATT and a digital-to-analog-converter DAC that are coupled to an amplifier AMP1. The amplifier AMP1 is coupled to a filter FI1, which in the shown example is provided as a low pass filter. The vertical system VS also comprises an analog-to-digital converter ADC1 that receives the output from the filter FI1 and converts the received analog signal into a digital signal.

The attenuator ATT and the amplifier AMP1 serve to scale the amplitude of the signal to be acquired to match the operation range of the analog-to-digital converter ADC1. The digital-to-analog-converter DAC1 serves to modify the DC component of the input signal to be acquired to match the operation range of the analog-to-digital converter ADC1. The filter FI1 serves to filter out unwanted high frequency components of the signal to be acquired.

The triggering section TS operates on the signal as provided by the amplifier AMP. The triggering section TS comprises a filter FI2, which in this embodiment is implemented as a low pass filter. The filter FI2 is coupled to a trigger system TS1.

The triggering section TS serves to capture predefined signal events and allows the horizontal system HS to e.g., display a stable view of a repeating waveform, or to simply display waveform sections that comprise the respective signal event. It is understood, that the predefined signal event may be configured by a user via a user input of the oscilloscope OSC.

Possible predefined signal events may for example include, but are not limited to, when the signal crosses a predefined trigger threshold in a predefined direction i.e., with a rising or falling slope. Such a trigger condition is also called an edge trigger. Another trigger condition is called "glitch triggering" and triggers, when a pulse occurs in the signal to be acquired that has a width that is greater than or less than a predefined amount of time.

In order to allow an exact matching of the trigger event and the waveform that is shown on the display DISP, a common time base may be provided for the analog-to-digital converter ADC1 and the trigger system TS1.

It is understood, that although not explicitly shown, the trigger system TS1 may comprise at least one of configurable voltage comparators for setting the trigger threshold voltage, fixed voltage sources for setting the required slope, respective logic gates like e.g., a XOR gate, and FlipFlops to generate the triggering signal.

The triggering section TS is exemplarily provided as an analog trigger section. It is understood, that the oscilloscope OSC may also be provided with a digital triggering section. Such a digital triggering section will not operate on the analog signal as provided by the amplifier AMP but will operate on the digital signal as provided by the analog-to-digital converter ADC1.

A digital triggering section may comprise a processing element, like a processor, a DSP, a CPLD, an ASIC or an FPGA to implement digital algorithms that detect a valid trigger event.

The horizontal system HS is coupled to the output of the trigger system TS1 and mainly serves to position and scale the signal to be acquired horizontally on the display DISP.

The oscilloscope OSC further comprises a processing section PS that implements digital signal processing and data storage for the oscilloscope OSC. The processing section PS comprises an acquisition processing element ACP that is couple to the output of the analog-to-digital converter ADC1 and the output of the horizontal system HS as well as to a memory MEM and a post processing element PPE.

The acquisition processing element ACP manages the acquisition of digital data from the analog-to-digital converter ADC1 and the storage of the data in the memory MEM. The acquisition processing element ACP may for example comprise a processing element with a digital interface to the analog-to-digital converter ADC2 and a digital interface to the memory MEM. The processing element may for example comprise a microcontroller, a DSP, a CPLD, an ASIC or an FPGA with respective interfaces. In a microcontroller or DSP, the functionality of the acquisition processing element ACP may be implemented as computer readable instructions that are executed by a CPU. In a CPLD or FPGA the functionality of the acquisition processing element ACP may be configured in to the CPLD or FPGA opposed to software being executed by a processor.

The processing section PS further comprises a communication processor CP and a communication interface COM.

The communication processor CP may be a device that manages data transfer to and from the oscilloscope OSC. The communication interface COM for any adequate communication standard like for example, Ethernet, WIFI, Bluetooth, NFC, an infra-red communication standard, and a visible-light communication standard.

The communication processor CP is coupled to the memory MEM and may use the memory MEM to store and retrieve data.

Of course, the communication processor CP may also be coupled to any other element of the oscilloscope OSC to retrieve device data or to provide device data that is received from the management server.

The post processing element PPE may be controlled by the acquisition processing element ACP and may access the memory MEM to retrieve data that is to be displayed on the display DISP. The post processing element PPE may condition the data stored in the memory MEM such that the display DISP may show the data e.g., as waveform to a user. The post processing element PPE may also realize analysis functions like cursors, waveform measurements, histograms, or math functions.

The display DISP controls all aspects of signal representation to a user, although not explicitly shown, may comprise any component that is required to receive data to be displayed and control a display device to display the data as required.

It is understood, that even if it is not shown, the oscilloscope OSC may also comprise a user interface for a user to interact with the oscilloscope OSC. Such a user interface may comprise dedicated input elements like for example knobs and switches. At least in part the user interface may also be provided as a touch sensitive display device.

It is understood, that all elements of the oscilloscope OSC that perform digital data processing may be provided as dedicated elements. As alternative, at least some of the above-described functions may be implemented in a single hardware element, like for example a microcontroller, DSP, CPLD or FPGA. Generally, the above-describe logical functions may be implemented in any adequate hardware element of the oscilloscope OSC and not necessarily need to be partitioned into the different sections explained above.

In the oscilloscope OSC any adequate element of the processing section PS may perform the digital functions or functions that require processing of the elements of the measurement application device. Further, the processing section PS may be provided with any element that may be required to provide the functionality of the elements of any of the implementations of the measurement application device described herein. Further, the processing section PS may be coupled to any other element of the oscilloscope OSC, especially, the triggering section, in order to provide the event signal to the respective sections.

The processes, methods, or algorithms disclosed herein can be deliverable to/imple-mented by a processing device, controller, or computer, which can include any existing programmable electronic control unit or dedicated electronic control unit. Similarly, the processes, methods, or algorithms can be stored as data and instructions executable by a controller or computer in many forms including, but not limited to, information permanently stored on non-writable storage media such as ROM devices and information al-terably stored on writeable storage media such as floppy disks, magnetic tapes, CDs, RAM devices, and other magnetic and optical media. The processes, methods, or algorithms can also be implemented in a software executable object. Alternatively, the processes, methods, or algorithms can be embodied in whole or in part using suitable hardware components, such as Application Specific Integrated Circuits (ASICs), Field-Programmable Gate Arrays (FPGAs), state machines, controllers or other hardware components or devices, or a combination of hardware, software and firmware components.

While exemplary embodiments are described above, it is not intended that these embodiments describe all possible forms encompassed by the claims. The words used in the specification are words of description rather than limitation, and it is understood that various changes can be made without departing from the spirit and scope of the disclosure. As previously described, the features of various embodiments can be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, which depend on the specific application and implementation. These attributes can include, but are not limited to cost, strength, durability, life cycle cost, marketability, appearance, packaging, size, serviceability, weight, manufacturability, ease of assembly, etc. As such, to the extent any embodiments are described as less desirable than other embodiments or prior art implementations with respect to one or more characteristics, these embodiments are not outside the scope of the disclosure and can be desirable for particular applications.

With regard to the processes, systems, methods, heuristics, etc. described herein, it should be understood that, although the steps of such processes, etc. have been described as occurring according to a certain ordered sequence, such processes could be practiced with the described steps performed in an order other than the order described herein. It further should be understood that certain steps could be performed simultaneously, that other steps could be added, or that certain steps described herein could be omitted. In other words, the descriptions of processes herein are provided for the purpose of illustrating certain embodiments, and should in no way be construed so as to limit the claims.

Accordingly, it is to be understood that the above description is intended to be illustrative and not restrictive. Many embodiments and applications other than the examples provided would be apparent upon reading the above description. The scope should be determined, not with reference to the above description, but should instead be determined with reference to the appended claims, along with the full scope of equivalents to which such claims are entitled. It is anticipated and intended that future developments will occur in the technologies discussed herein, and that the disclosed systems and methods will be incorporated into such future embodiments. In sum, it should be understood that the application is capable of modification and variation.

All terms used in the claims are intended to be given their broadest reasonable constructions and their ordinary meanings as understood by those knowledgeable in the technologies described herein unless an explicit indication to the contrary in made herein. In particular, use of the singular articles such as "a," "the," "said," etc. should be read to recite one or more of the indicated elements unless a claim recites an explicit limitation to the contrary.

The abstract of the disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separately claimed subject matter.

While exemplary embodiments are described above, it is not intended that these embodiments describe all possible forms of the invention. Rather, the words used in the specification are words of description rather than limitation, and it is understood that various changes may be made without departing from the scope of the invention. Additionally, the features of various implementing embodiments may be combined to form further embodiments of the invention.

### LIST OF REFERENCE SIGNS

- 100, 200, 300, 400, 500, 600: measurement application device
- 700-1 - 700-n, 800-1 - 800-n: measurement application device
- 101, 201, 301, 401, 501, 601: synchronization interface
- 102, 202, 302, 402, 502, 602: synchronization signal

- 105, 205, 305, 405, 505, 605: counter
- 106, 206, 306, 406, 506, 606: counter signal

- 108, 208, 308, 408, 508, 608: event signal generator
- 109-1 - 109-n, 209-1 - 209-n: event time
- 309-1 - 309-n, 409-1 - 409-n: event time
- 509-1 - 509-n, 609-1 - 609-n: event time
- 110-1 - 110-n, 210-1 - 210-n: event signal
- 310-1 - 310-n, 410-1 - 410-n: event signal
- 510-1 - 510-n, 610-1 - 610-n: event signal

- 215: analog signal processing unit
- 216: qubit controller
- 217: control signal
- 218: digital signal processing unit

- 220: digital event time
- 221: analog event time
- 222: digital domain event signal
- 223: analog domain event signal

- 325: event control interface
- 326: event time data

- 430, 530: sequencer
- 431, 531: sequence
- 432-1 - 432, 532-1 - 532-n: sequence command
- 433, 533: arbitrary output signal sequence
- 434, 534: input signal

- 535-1 - 535-n: sequence command queue
- 536: feedback signal

- 640: monitor

- 750, 850: signal processing system
- 751, 851: synchronization signal source
- 752, 852: event controller

- 860: quantum computer
- 861: qubit control unit
- 862-1 - 862-n: qubit
- 863: qubit section

- OSC1: oscilloscope
- HO: housing
- MIP1, MIP2, MIP3, MIP4: measurement input
- SIP: signal processing
- DISP1: display

- OSC: oscilloscope
- VS: vertical system
- SC: signal conditioning
- ATT: attenuator
- DAC1: analog-to-digital converter
- AMP1: amplifier
- FI1: filter
- ADC1: analog-to-digital converter

- TS: triggering section
- AMP2: amplifier
- FI2: filter
- TS1: trigger system

- HS: horizontal system

- PS: processing section
- ACP: acquisition processing element
- MEM: memory
- PPE: post processing element

- DISP: display

## Claims

1. A measurement application device (100, 200, 300, 400, 500, 600, 700-1 - 700-n, 800-1 - 800-n) comprising:
a synchronization interface (101, 201, 301, 401, 501, 601) configured to receive synchronization signals (102, 202, 302, 402, 502, 602);
a counter (105, 205, 305, 405, 505, 605) coupled to the synchronization interface (101, 201, 301, 401, 501, 601), and configured to at least one of initiate and perform counting based on the received synchronization signals (102, 202, 302, 402, 502, 602) and provide a respective counter signal (106, 206, 306, 406, 506, 606);
an event signal generator (108, 208, 308, 408, 508, 608) coupled to the counter (105, 205, 305, 405, 505, 605), and configured to generate a respective event signal (110-1 - 110-n, 210-1 - 210-n, 310-1 - 310-n, 410-1 - 410-n, 510-1 - 510-n, 610-1 - 610-n) based on the counter signal (106, 206, 306, 406, 506, 606) for each one of at least one predetermined event time (109-1 - 109-n, 209-1 - 209-n, 309-1 - 309-n, 409-1 - 409-n, 509-1 - 509-n, 609-1 - 609-n);
an analog signal processing unit (215) coupled to the event signal generator (108, 208, 308, 408, 508, 608), and configured to perform and control a signal generation or a signal acquisition based on the generated event signals (110-1 - 110-n, 210-1 - 210-n, 310-1 - 310-n, 410-1 - 410-n, 510-1 - 510-n, 610-1 - 610-n); and
a digital signal processing unit (218) coupled to the event signal generator (108, 208, 308, 408, 508, 608) and configured to perform digital signal processing at least in part based on the generated event signals (110-1 - 110-n, 210-1 - 210-n, 310-1 - 310-n, 410-1 - 410-n, 510-1 - 510-n, 610-1 - 610-n);
**characterized in that**
the analog signal processing unit (215) and the digital signal processing unit (218) together form at least one qubit controller (216) configured to control at least one qubit (862-1 - 862-n)..

2. The measurement application device (100, 200, 300, 400, 500, 600, 700-1 - 700-n, 800-1 - 800-n) according to claim 1, wherein the event signal generator (108, 208, 308, 408, 508, 608) is configured to generate the respective event signal (110-1 - 110-n, 210-1 - 210-n, 310-1 - 310-n, 410-1 - 410-n, 510-1 - 510-n, 610-1 - 610-n) when a counter value indicated by the counter signal (106, 206, 306, 406, 506, 606) is equal to a respective one of the at least one predetermined event time (109-1 - 109-n, 209-1 - 209-n, 309-1 - 309-n, 409-1 - 409-n, 509-1 - 509-n, 609-1 - 609-n).

3. The measurement application device (100, 200, 300, 400, 500, 600, 700-1 - 700-n, 800-1 - 800-n) according to claim 1, wherein the analog signal processing unit (215) operates at a first frequency that is higher than a second frequency at which the digital signal processing unit (218) operates;
wherein the counter (105, 205, 305, 405, 505, 605) is configured to count with the first frequency; and
wherein the event signal generator (108, 208, 308, 408, 508, 608) is configured to at least one of generate a respective digital domain event signal (222) according to the second frequency, and generate an analog domain event signal (223) according to the first frequency.

4. The measurement application device (100, 200, 300, 400, 500, 600, 700-1 - 700-n, 800-1 - 800-n) according to claim 3, wherein the at least one event time (109-1 - 109-n, 209-1 - 209-n, 309-1 - 309-n, 409-1 - 409-n, 509-1 - 509-n, 609-1 - 609-n) comprises at least one of:
an individual predetermined digital event time (220) for the digital domain event signal; and
an individual predetermined analog event time (221) for the analog domain event signal.

5. The measurement application device (100, 200, 300, 400, 500, 600, 700-1 - 700-n, 800-1 - 800-n) according to any one of the preceding claims, further comprising an event control interface (325) coupled to the event signal generator (108, 208, 308, 408, 508, 608), and configured to receive event time data (326) representing the predetermined event time (109-1 - 109-n, 209-1 - 209-n, 309-1 - 309-n, 409-1 - 409-n, 509-1 - 509-n, 609-1 - 609-n); and
wherein the event signal generator (108, 208, 308, 408, 508, 608) is configured to determine the predetermined event data based on the received event time data (326).

6. The measurement application device (100, 200, 300, 400, 500, 600, 700-1 - 700-n, 800-1 - 800-n) according to claim 5, wherein the event time data (326) comprises information about an earliest possible event time (109-1 - 109-n, 209-1 - 209-n, 309-1 - 309-n, 409-1 - 409-n, 509-1 - 509-n, 609-1 - 609-n) of at least one further measurement application device (100, 200, 300, 400, 500, 600, 700-1 - 700-n, 800-1 - 800-n);
wherein the event signal generator (108, 208, 308, 408, 508, 608) is configured to determine an earliest possible event time (109-1 - 109-n, 209-1 - 209-n, 309-1 - 309-n, 409-1 - 409-n, 509-1 - 509-n, 609-1 - 609-n) for the measurement application device (100, 200, 300, 400, 500, 600, 700-1 - 700-n, 800-1 - 800-n); and
wherein the event signal generator (108, 208, 308, 408, 508, 608) is configured to at least one of:
output the determined earliest possible event time (109-1 - 109-n, 209-1 - 209-n, 309-1 - 309-n, 409-1 - 409-n, 509-1 - 509-n, 609-1 - 609-n), and
determine a next event time (109-1 - 109-n, 209-1 - 209-n, 309-1 - 309-n, 409-1 - 409-n, 509-1 - 509-n, 609-1 - 609-n) as the latest one of the earliest possible event time (109-1 - 109-n, 209-1 - 209-n, 309-1 - 309-n, 409-1 - 409-n, 509-1 - 509-n, 609-1 - 609-n) determined for the measurement application device (100, 200, 300, 400, 500, 600, 700-1 - 700-n, 800-1 - 800-n), and the received earliest possible event time (109-1 - 109-n, 209-1 - 209-n, 309-1 - 309-n, 409-1 - 409-n, 509-1 - 509-n, 609-1 - 609-n) of the at least one further measurement application device (100, 200, 300, 400, 500, 600, 700-1 - 700-n, 800-1 - 800-n).

7. The measurement application device (100, 200, 300, 400, 500, 600, 700-1 - 700-n, 800-1 - 800-n) according to any one of the preceding claims, further comprising a sequencer (430, 530) coupled to the counter (105, 205, 305, 405, 505, 605), and configured to at least one of generate an arbitrary output signal sequence (433, 533), or acquire and process input signals (434, 534) based on a predetermined sequence (431, 531) comprising sequence commands (432-1 - 432, 532-1 - 532-n) and a command time associated with at least one of the sequence commands (432-1 - 432, 532-1 - 532-n) and the counter signal (106, 206, 306, 406, 506, 606).

8. The measurement application device (100, 200, 300, 400, 500, 600, 700-1 - 700-n, 800-1 - 800-n) according to claim 7, wherein the sequencer (430, 530) is configured to apply preprocessing functions to the single elements of the output signal sequence in advance such that the respective elements are output according to the sequence commands (432-1 - 432, 532-1 - 532-n) and the command times provided in the sequence (431, 531).

9. The measurement application device (100, 200, 300, 400, 500, 600, 700-1 - 700-n, 800-1 - 800-n) according to claim 7, wherein the sequencer (430, 530) is configured:
to create individual sequence command queues (535-1 - 535-n) for individual branches in the sequence (431, 531); and
to receive a feedback signal (536); and
to execute the sequence (431, 531) using the individual sequence command queues (535-1 - 535-n) based on the feedback signal (536) and the command times provided in the sequence (431, 531).

10. The measurement application device (100, 200, 300, 400, 500, 600, 700-1 - 700-n, 800-1 - 800-n) according to claim 1, further comprising a monitor (640) configured to monitor the operation of the measurement application device (100, 200, 300, 400, 500, 600, 700-1 - 700-n, 800-1 - 800-n) for compliance with the at least one predetermined event time (109-1 - 109-n, 209-1 - 209-n, 309-1 - 309-n, 409-1 - 409-n, 509-1 - 509-n, 609-1 - 609-n).

11. A signal processing system (750, 850) comprising:
at least two measurement application devices (100, 200, 300, 400, 500, 600, 700-1 - 700-n, 800-1 - 800-n) according to any one of the preceding claims;
a synchronization signal source (751, 851) coupled to the at least two measurement application devices (100, 200, 300, 400, 500, 600, 700-1 - 700-n, 800-1 - 800-n) via their respective synchronization interfaces (101, 201, 301, 401, 501, 601), and configured to provide the measurement application devices (100, 200, 300, 400, 500, 600, 700-1 - 700-n, 800-1 - 800-n) the synchronization signals (102, 202, 302, 402, 502, 602); and
an event controller (752, 852) coupled to the at least two measurement application devices (100, 200, 300, 400, 500, 600, 700-1 - 700-n, 800-1 - 800-n), and configured to provide the at least one predetermined event time (109-1 - 109-n, 209-1 - 209-n, 309-1 - 309-n, 409-1 - 409-n, 509-1 - 509-n, 609-1 - 609-n) to the at least two measurement application devices (100, 200, 300, 400, 500, 600, 700-1 - 700-n, 800-1 - 800-n).

12. A qubit control unit (861) comprising:
at least one signal processing system (750, 850) according to the preceding claim.

13. A quantum computer (860) comprising:
at least one qubit control unit (861) according to the preceding claim; and
at least one qubit (862-1 - 862-n) coupled to the at least one qubit control unit (861).

## Patentansprüche

1. Messanwendungsvorrichtung (100, 200, 300, 400, 500, 600, 700-1 - 700-n, 800-1 - 800-n), umfassend:
eine Synchronisationsschnittstelle (101, 201, 301, 401, 501, 601), die konfiguriert ist, um Synchronisationssignale (102, 202, 302, 402, 502, 602) zu empfangen;
einen Zähler (105, 205, 305, 405, 505, 605), der mit der Synchronisationsschnittstelle (101, 201, 301, 401, 501, 601) gekoppelt und konfiguriert ist, um basierend auf den empfangenen Synchronisationssignalen (102, 202, 302, 402, 502, 602) ein Zählen zu initiieren und/oder durchzuführen und ein jeweiliges Zählersignal (106, 206, 306, 406, 506, 606) bereitzustellen;
einen Ereignissignalgenerator (108, 208, 308, 408, 508, 608), der mit dem Zähler (105, 205, 305, 405, 505, 605) gekoppelt und konfiguriert ist, um ein jeweiliges Ereignissignal (110-1 - 110-n, 210-1 - 210-n, 310-1 - 310-n, 410-1 - 410-n, 510-1 - 510-n, 610-1 - 610-n) basierend auf dem Zählersignal (106, 206, 306, 406, 506, 606) für jede von mindestens einer vorbestimmten Ereigniszeit (109-1 - 109-n, 209-1 - 209-n, 309-1 - 309-n, 409-1 - 409-n, 509-1 - 509-n, 609-1 - 609-n) zu generieren;
eine analoge Signalverarbeitungseinheit (215), die mit dem Ereignissignalgenerator (108, 208, 308, 408, 508, 608) gekoppelt und konfiguriert ist, um basierend auf den generierten Ereignissignalen (110-1 - 110-n, 210-1 - 210-n, 310-1 - 310-n, 410-1 - 410-n, 510-1 - 510-n, 610-1 - 610-n) eine Signalgenerierung oder eine Signalerfassung durchzuführen und zu steuern; und
eine digitale Signalverarbeitungseinheit (218), die mit dem Ereignissignalgenerator (108, 208, 308, 408, 508, 608) gekoppelt und konfiguriert ist, um eine digitale Signalverarbeitung mindestens teilweise basierend auf den generierten Ereignissignalen (110-1 - 110-n, 210-1 - 210-n, 310-1 - 310-n, 410-1 - 410-n, 510-1 - 510-n, 610-1 - 610-n) durchzuführen;
**dadurch gekennzeichnet, dass**
die analoge Signalverarbeitungseinheit (215) und die digitale Signalverarbeitungseinheit (218) zusammen mindestens eine Qubit-Steuerung (216) ausbilden, die konfiguriert ist, um mindestens ein Qubit (862-1 - 862-n) zu steuern.

2. Messanwendungsvorrichtung (100, 200, 300, 400, 500, 600, 700-1 - 700-n, 800-1 - 800-n) nach Anspruch 1, wobei der Ereignissignalgenerator (108, 208, 308, 408, 508, 608) konfiguriert ist, um das jeweilige Ereignissignal (110-1 - 110-n, 210-1 - 210-n, 310-1 - 310-n, 410-1 - 410-n, 510-1 - 510-n, 610-1 - 610-n) zu generieren, wenn ein Zählerwert, der durch das Zählersignal (106, 206, 306, 406, 506, 606) angezeigt wird, gleich einer jeweiligen der mindestens einen vorbestimmten Ereigniszeit (109-1 - 109-n, 209-1 -209-n, 309-1 - 309-n, 409-1 - 409-n, 509-1 - 509-n, 609-1 - 609-n) ist.

3. Messanwendungsvorrichtung (100, 200, 300, 400, 500, 600, 700-1 - 700-n, 800-1 - 800-n) nach Anspruch 1, wobei die analoge Signalverarbeitungseinheit (215) mit einer ersten Frequenz betrieben wird, die höher als eine zweite Frequenz ist, mit der die digitale Signalverarbeitungseinheit (218) betrieben wird;
wobei der Zähler (105, 205, 305, 405, 505, 605) konfiguriert ist, um mit der ersten Frequenz zu zählen; und
wobei der Ereignissignalgenerator (108, 208, 308, 408, 508, 608)konfiguriert ist, um mindestens eines von ein jeweiliges Digitalbereichereignissignal (222) gemäß der zweiten Frequenz zu generieren und ein Analogbereichereignissignal (223) gemäß der ersten Frequenz zu generieren.

4. Messanwendungsvorrichtung (100, 200, 300, 400, 500, 600, 700-1 - 700-n, 800-1 - 800-n) nach Anspruch 3, wobei die mindestens eine Ereigniszeit (109-1 - 109-n, 209-1 - 209-n, 309-1 - 309-n, 409-1 - 409-n, 509-1 - 509-n, 609-1 - 609-n) mindestens eines umfasst von:
einer individuellen vorbestimmten digitalen Ereigniszeit (220) für das Digitalbereichereignissignal; und
einer individuellen vorbestimmten analogen Ereigniszeit (221) für das Analogbereichereignissignal.

5. Messanwendungsvorrichtung (100, 200, 300, 400, 500, 600, 700-1 - 700-n, 800-1 - 800-n) nach einem der vorstehenden Ansprüche, ferner umfassend eine Ereignissteuerschnittstelle (325), die mit dem Ereignissignalgenerator (108, 208, 308, 408, 508, 608) gekoppelt und konfiguriert ist, um Ereigniszeitdaten (326) zu sammeln, die die vorbestimmte Ereigniszeit (109-1 - 109-n, 209-1 - 209-n, 309-1 - 309-n, 409-1 - 409-n, 509-1 - 509-n, 609-1 - 609-n) darstellen; und
wobei der Ereignissignalgenerator (108, 208, 308, 408, 508, 608) konfiguriert ist, um die vorbestimmten Ereignisdaten basierend auf den empfangenen Ereigniszeitdaten (326) zu bestimmen.

6. Messanwendungsvorrichtung (100, 200, 300, 400, 500, 600, 700-1 - 700-n, 800-1 - 800-n) nach Anspruch 5, wobei die Ereigniszeitdaten (326) Informationen über eine frühestmögliche Ereigniszeit (109-1 - 109-n, 209-1 - 209-n, 309-1 - 309-n, 409-1 - 409-n, 509-1 - 509-n, 609-1 - 609-n) mindestens einer weiteren Messanwendungsvorrichtung (100, 200, 300, 400, 500, 600, 700-1 - 700- n, 800-1 - 800-n) umfasst;
wobei der Ereignissignalgenerator (108, 208, 308, 408, 508, 608) konfiguriert ist, um eine frühestmögliche Ereigniszeit (109-1 - 109-n, 209-1 - 209-n, 309-1 - 309-n, 409-1 - 409-n, 509-1 - 509-n, 609-1 - 609-n) für die Messanwendungsvorrichtung (100, 200, 300, 400, 500, 600, 700-1 - 700-n, 800-1 - 800-n) zu bestimmen; und
wobei der Ereignissignalgenerator (108, 208, 308, 408, 508, 608) für mindestens eines konfiguriert ist von:
Ausgeben der bestimmten frühestmöglichen Ereigniszeit (109-1 - 109-n, 209-1 - 209-n, 309-1 - 309-n, 409-1 - 409-n, 509-1 - 509-n, 609-1 - 609-n), und
Bestimmen einer nächsten Ereigniszeit (109-1 - 109-n, 209-1 - 209-n, 309-1 - 309-n, 409-1 - 409-n, 509-1 - 509-n, 609-1 - 609-n) als die späteste der frühestmöglichen Ereigniszeit (109-1 - 109-n, 209-1 - 209-n, 309-1 - 309-n, 409-1 - 409- n, 509-1 - 509-n, 609-1 - 609-n), die für die Messanwendungsvorrichtung (100, 200, 300, 400, 500, 600, 700-1 - 700-n, 800-1 - 800-n) bestimmt wird, und der empfangenen frühestmöglichen Ereigniszeit (109-1 - 109-n, 209-1 - 209-n, 309-1 - 309-n, 409-1 - 409-n, 509-1 - 509-n, 609-1 - 609-n) der mindestens einen weiteren Messanwendungsvorrichtung (100, 200, 300, 400, 500, 600, 700-1 - 700-n, 800-1 - 800-n).

7. Messanwendungsvorrichtung (100, 200, 300, 400, 500, 600, 700-1 - 700-n, 800-1 - 800-n) nach einem der vorstehenden Ansprüche, ferner umfassend einen Sequenzer (430, 530), der mit dem Zähler (105, 205, 305, 405, 505, 605) gekoppelt und konfiguriert ist, um mindestens eines von eine willkürliche Ausgangssignalsequenz (433, 533) zu generieren oder Eingangssignale (434, 534) basierend auf einer vorbestimmten Sequenz (431, 531) zu erfassen und zu verarbeiten, umfassend Sequenzbefehle (432-1 -432, 532-1 - 532-n) und eine Befehlszeit, die mit mindestens einem der Sequenzbefehle (432-1 - 432, 532-1 - 532-n) und dem Zählersignal (106, 206, 306, 406, 506, 606) verknüpft ist.

8. Messanwendungsvorrichtung (100, 200, 300, 400, 500, 600, 700-1 - 700-n, 800-1 - 800-n) nach Anspruch 7, wobei der Sequenzer (430, 530) konfiguriert ist, um Vorverarbeitungsfunktionen auf die einzelnen Elemente der Ausgangssignalsequenz im Voraus derart anzuwenden, dass die jeweiligen Elemente gemäß den Sequenzbefehlen (432-1 - 432, 532-1 - 532-n) und den Befehlszeiten ausgegeben werden, die in der Sequenz (431, 531) bereitgestellt werden.

9. Messanwendungsvorrichtung (100, 200, 300, 400, 500, 600, 700-1 - 700-n, 800-1 - 800-n) nach Anspruch 7, wobei der Sequenzer (430, 530) konfiguriert ist:
um individuelle Sequenzbefehlswarteschlangen (535-1 - 535-n) für individuelle Zweige in der Sequenz (431, 531) zu erzeugen; und
um ein Rückkopplungssignal (536) zu empfangen; und
um die Sequenz (431, 531) unter Verwendung der individuellen Sequenzbefehlswarteschlangen (535-1 - 535-n) basierend auf dem Rückkopplungssignal (536) und den Befehlszeiten auszuführen, die in der Sequenz (431, 531) bereitgestellt werden.

10. Messanwendungsvorrichtung (100, 200, 300, 400, 500, 600, 700-1 - 700-n, 800-1 - 800-n) nach Anspruch 1, ferner umfassend einen Monitor (640), der konfiguriert ist, um den Betrieb der Messanwendungsvorrichtung (100, 200, 300, 400, 500, 600, 700-1 - 700-n, 800-1 - 800-n) auf Einhaltung der mindestens einen vorbestimmten Ereigniszeit (109-1 - 109-n, 209-1 - 209-n, 309-1 - 309-n, 409-1 - 409-n, 509-1 - 509-n, 609-1 - 609-n) zu überwachen.

11. Signalverarbeitungssystem (750, 850), umfassend:
mindestens zwei Messanwendungsvorrichtungen (100, 200, 300, 400, 500, 600, 700-1 - 700-n, 800-1 - 800-n) nach einem der vorstehenden Ansprüche;
eine Synchronisationssignalquelle (751, 851), die mit den mindestens zwei Messanwendungsvorrichtungen (100, 200, 300, 400, 500, 600, 700-1 - 700-n, 800-1 - 800-n) über ihre jeweiligen Synchronisationsschnittstellen (101, 201, 301, 401, 501, 601) gekoppelt und konfiguriert ist, um den Messanwendungsvorrichtungen (100, 200, 300, 400, 500, 600, 700-1 - 700-n, 800-1 - 800-n) die Synchronisationssignale (102, 202, 302, 402, 502, 602) bereitzustellen; und
eine Ereignissteuerung (752, 852), die mit den mindestens zwei Messanwendungsvorrichtungen (100, 200, 300, 400, 500, 600, 700-1 - 700-n, 800-1 - 800-n) gekoppelt und konfiguriert ist, um den mindestens zwei Messanwendungsvorrichtungen (100, 200, 300, 400, 500, 600, 700-1 - 700-n, 800-1 - 800-n) die mindestens eine vorbestimmte Ereigniszeit (109-1 - 109-n, 209-1 - 209-n, 309-1 - 309-n, 409-1 - 409-n, 509-1 - 509-n, 609-1 - 609-n) bereitzustellen.

12. Qubit-Steuereinheit (861), umfassend:
mindestens ein Signalverarbeitungssystem (750, 850) nach dem vorstehenden Anspruch.

13. Quantencomputer (860) umfassend:
mindestens eine Qubit-Steuereinheit (861) nach dem vorstehenden Anspruch; und
mindestens ein Qubit (862-1 - 862-n), das an die mindestens eine Qubit-Steuereinheit (861) gekoppelt ist.

## Revendications

1. Dispositif d'application de mesure (100, 200, 300, 400, 500, 600, 700-1 à 700-n, 800-1 à 800-n) comprenant :
une interface de synchronisation (101, 201, 301, 401, 501, 601) configurée pour recevoir des signaux de synchronisation (102, 202, 302, 402, 502, 602) ;
un compteur (105, 205, 305, 405, 505, 605) couplé à l'interface de synchronisation (101, 201, 301, 401, 501, 601), et configuré pour au moins l'un parmi lancer et effectuer un comptage sur la base des signaux de synchronisation (102, 202, 302, 402, 502, 602) reçus et fournir un signal de compteur (106, 206, 306, 406, 506, 606) respectif ;
un générateur de signaux d'événement (108, 208, 308, 408, 508, 608) couplé au compteur (105, 205, 305, 405, 505, 605), et configuré pour générer un signal d'événement (110-1 à 110-n, 210-1 à 210-n, 310-1 à 310-n, 410-1 à 410-n, 510-1 à 510-n, 610-1 à 610-n) respectif sur la base du signal de compteur (106, 206, 306, 406, 506, 606) pour chacun d'au moins un instant d'événement (109-1 à 109-n, 209-1 à 209-n, 309-1 à 309-n, 409-1 à 409-n, 509-1 à 509-n, 609-1 à 609-n) prédéterminé ;
une unité de traitement de signal analogique (215) couplée au générateur de signaux d'événement (108, 208, 308, 408, 508, 608), et configurée pour effectuer et commander une génération de signal ou une acquisition de signal sur la base des signaux d'événement (110-1 à 110-n, 210-1 à 210-n, 310-1 à 310-n, 410-1 à 410-n, 510-1 à 510-n, 610-1 à 610-n) générés ; et
une unité de traitement de signal numérique (218) couplée au générateur de signaux d'événement (108, 208, 308, 408, 508, 608) et configurée pour effectuer un traitement de signal numérique au moins en partie sur la base des signaux d'événement (110-1 à 110-n, 210-1 à 210-n, 310-1 à 310-n, 410-1 à 410-n, 510-1 à 510-n, 610-1 à 610-n) générés ;
**caractérisé en ce que**
l'unité de traitement de signal analogique (215) et l'unité de traitement de signal numérique (218) forment ensemble au moins un dispositif de commande de qubit (216) configuré pour commander au moins un qubit (862-1 -862-n).

2. Dispositif d'application de mesure (100, 200, 300, 400, 500, 600, 700-1 à 700-n, 800-1 à 800-n) selon la revendication 1, dans lequel le générateur de signaux d'événement (108, 208, 308, 408, 508, 608) est configuré pour générer le signal d'événement (110-1 à 110-n, 210-1 à 210-n, 310-1 à 310-n, 410-1 à 410-n, 510-1 à 510-n, 610-1 à 610-n) respectif lorsqu'une valeur de compteur indiquée par le signal de compteur (106, 206, 306, 406, 506, 606) est égale à un instant respectif de l'au moins un instant d'événement (109-1 à 109-n, 209-1 à 209-n, 309-1 à 309-n, 409-1 à 409-n, 509-1 à 509-n, 609-1 à 609-n) prédéterminé.

3. Dispositif d'application de mesure (100, 200, 300, 400, 500, 600, 700-1 à 700-n, 800-1 à 800-n) selon la revendication 1, dans lequel l'unité de traitement de signal analogique (215) fonctionne à une première fréquence qui est supérieure à une seconde fréquence à laquelle l'unité de traitement de signal numérique (218) fonctionne ;
dans lequel le compteur (105, 205, 305, 405, 505, 605) est configuré pour compter à la première fréquence ; et
dans lequel le générateur de signaux d'événement (108, 208, 308, 408, 508, 608) est configuré pour au moins l'un parmi générer un signal d'événement de domaine numérique (222) respectif selon la seconde fréquence, et générer un signal d'événement de domaine analogique (223) selon la première fréquence.

4. Dispositif d'application de mesure (100, 200, 300, 400, 500, 600, 700-1 à 700-n, 800-1 à 800-n) selon la revendication 3, dans lequel l'au moins un instant d'événement (109-1 à 109-n, 209-1 à 209-n, 309-1 à 309-n, 409-1 à 409-n, 509-1 à 509-n, 609-1 à 609-n) comprend au moins l'un parmi :
un instant d'événement numérique prédéterminé individuel (220) pour le signal d'événement de domaine numérique ; et
un instant d'événement analogique prédéterminé individuel (221) pour le signal d'événement de domaine analogique.

5. Dispositif d'application de mesure (100, 200, 300, 400, 500, 600, 700-1 à 700-n, 800-1 à 800-n) selon l'une quelconque des revendications précédentes, comprenant en outre une interface de commande d'événement (325) couplée au générateur de signaux d'événement (108, 208, 308, 408, 508, 608), et configurée pour recevoir des données d'instant d'événement (326) représentant l'instant d'événement (109-1 à 109-n, 209-1 à 209-n, 309-1 à 309-n, 409-1 à 409-n, 509-1 à 509-n, 609-1 à 609-n) prédéterminé ; et
dans lequel le générateur de signaux d'événement (108, 208, 308, 408, 508, 608) est configuré pour déterminer des données d'événement prédéterminées sur la base des données d'instant d'événement (326) reçues.

6. Dispositif d'application de mesure (100, 200, 300, 400, 500, 600, 700-1 à 700-n, 800-1 à 800-n) selon la revendication 5, dans lequel les données d'instant d'événement (326) comprennent des informations sur un instant d'événement possible le plus précoce (109-1 à 109-n, 209-1 à 209-n, 309-1 à 309-n, 409-1 à 409-n, 509-1 à 509-n, 609-1 à 609-n) d'au moins un autre dispositif d'application de mesure (100, 200, 300, 400, 500, 600, 700-1 à 700- n, 800-1 à 800-n) ;
dans lequel le générateur de signaux d'événement (108, 208, 308, 408, 508, 608) est configuré pour déterminer un instant d'événement possible le plus précoce (109-1 à 109-n, 209-1 à 209-n, 309-1 à 309-n, 409-1 à 409-n, 509-1 à 509-n, 609-1 à 609-n) pour le dispositif d'application de mesure (100, 200, 300, 400, 500, 600, 700-1 à 700-n, 800-1 à 800-n) ; et
dans lequel le générateur de signaux d'événement (108, 208, 308, 408, 508, 608) est configuré pour au moins l'un parmi :
délivrer l'instant d'événement possible le plus précoce (109-1 à 109-n, 209-1 à 209- n, 309-1 à 309-n, 409-1 à 409-n, 509-1 à 509-n, 609-1 à 609-n) déterminé, et
déterminer un instant d'événement (109-1 à 109-n, 209-1 à 209-n, 309-1 à 309-n, 409-1 à 409-n, 509-1 à 509-n, 609-1 à 609-n) suivant comme étant le plus tardif de l'instant d'événement possible le plus précoce (109-1 à 109-n, 209-1 à 209-n, 309-1 à 309-n, 409-1 à 409- n, 509-1 à 509-n, 609-1 à 609-n) déterminé pour le dispositif d'application de mesure (100, 200, 300, 400, 500, 600, 700-1 à 700-n, 800-1 à 800-n), et l'instant d'événement possible le plus précoce (109-1 à 109-n, 209-1 à 209-n, 309-1 à 309-n, 409-1 à 409-n, 509-1 à 509-n, 609-1 à 609-n) reçu de l'au moins un autre dispositif d'application de mesure (100, 200, 300, 400, 500, 600, 700-1 à 700-n, 800-1 à 800-n).

7. Dispositif d'application de mesure (100, 200, 300, 400, 500, 600, 700-1 à 700-n, 800-1 à 800-n) selon l'une quelconque des revendications précédentes, comprenant en outre un séquenceur (430, 530) couplé au compteur (105, 205, 305, 405, 505, 605), et configuré pour au moins l'un parmi générer une séquence de signaux de sortie arbitraire (433, 533), ou acquérir et traiter des signaux d'entrée (434, 534) sur la base d'une séquence prédéterminée (431, 531) comprenant des instructions de séquence (432-1 -432, 532-1 à 532-n) et un instant d'instruction associé à au moins l'une des instructions de séquence (432-1 -432, 532-1 à 532-n) et au signal de compteur (106, 206, 306, 406, 506, 606).

8. Dispositif d'application de mesure (100, 200, 300, 400, 500, 600, 700-1 à 700-n, 800-1 à 800-n) selon la revendication 7, dans lequel le séquenceur (430, 530) est configuré pour appliquer à l'avance des fonctions de prétraitement aux éléments individuels de la séquence de signaux de sortie de telle sorte que les éléments respectifs sont délivrés selon les instructions de séquence (432-1 à 432, 532-1 à 532-n) et les instants d'instruction fournis dans la séquence (431, 531).

9. Dispositif d'application de mesure (100, 200, 300, 400, 500, 600, 700-1 à 700-n, 800-1 à 800-n) selon la revendication 7, dans lequel le séquenceur (430, 530) est configuré :
pour créer des files d'attente d'instructions de séquence individuelles (535-1 à 535-n) pour des branches individuelles dans la séquence (431, 531) ; et
pour recevoir un signal de rétroaction (536) ; et
pour exécuter la séquence (431, 531) à l'aide des files d'attente d'instructions de séquence individuelles (535-1 à 535-n) sur la base du signal de rétroaction (536) et des instants d'instruction fournis dans la séquence (431, 531).

10. Dispositif d'application de mesure (100, 200, 300, 400, 500, 600, 700-1 à 700-n, 800-1 à 800-n) selon la revendication 1, comprenant en outre un dispositif de surveillance (640) configuré pour surveiller le fonctionnement du dispositif d'application de mesure (100, 200, 300, 400, 500, 600, 700-1 à 700-n, 800-1 à 800-n) quant à la conformité avec l'au moins un instant d'événement (109-1 à 109-n, 209-1 à 209-n, 309-1 à 309-n, 409-1 à 409-n, 509-1 à 509-n, 609-1 à 609-n) prédéterminé.

11. Système de traitement de signaux (750, 850) comprenant :
au moins deux dispositifs d'application de mesure (100, 200, 300, 400, 500, 600, 700-1 à 700-n, 800-1 à 800-n) selon l'une quelconque des revendications précédentes ;
une source de signaux de synchronisation (751, 851) couplée aux au moins deux dispositifs d'application de mesure (100, 200, 300, 400, 500, 600, 700-1 à 700-n, 800-1 à 800-n) par l'intermédiaire de leurs interfaces de synchronisation (101, 201, 301, 401, 501, 601) respectives, et configurée pour fournir aux dispositifs d'application de mesure (100, 200, 300, 400, 500, 600, 700-1 à 700-n, 800-1 à 800-n) les signaux de synchronisation (102, 202, 302, 402, 502, 602) ; et
un dispositif de commande d'événement (752, 852) couplé aux au moins deux dispositifs d'application de mesure (100, 200, 300, 400, 500, 600, 700-1 à 700-n, 800-1 à 800-n), et configuré pour fournir l'au moins un instant d'événement (109-1 à 109-n, 209-1 à 209-n, 309-1 à 309-n, 409-1 à 409-n, 509-1 à 509-n, 609-1 à 609-n) prédéterminé aux au moins deux dispositifs d'application de mesure (100, 200, 300, 400, 500, 600, 700-1 à 700-n, 800-1 à 800-n).

12. Unité de commande de qubit (861) comprenant :
au moins un système de traitement de signaux (750, 850) selon la revendication précédente.

13. Ordinateur quantique (860) comprenant :
au moins une unité de commande de qubit (861) selon la revendication précédente ; et
au moins un qubit (862-1 à 862-n) couplé à l'au moins une unité de commande de qubit (861).
